# EUROPEAN PATENT APPLICATION

(11) **EP 4 801 227 A1**
(43) Date of publication of application: **02.09.2026**
(21) Application number: 25816156.1
(22) Date of filing: 03.04.2025
(51) Int. Cl.: H10H 20/857, H10H 20/855, H10H 20/85, H01L 25/075, H10H 20/01

(54) **LIGHT SOURCE APPARATUS AND METHOD FOR MANUFACTURING LIGHT SOURCE APPARATUS**

(30) Priority: 31.05.2024 KR 20240072028
(71) Applicant: Samsung Electronics Co., Ltd., Suwon-si, Gyeonggi-do 16677 (KR)
(72) Inventor: KIM, Taeyeon, Suwon-si Gyeonggi-do 16677 (KR); PARK, Chunsoon, Suwon-si Gyeonggi-do 16677 (KR); JANG, Hyukjun, Suwon-si Gyeonggi-do 16677 (KR); KIM, Sungyeol, Suwon-si Gyeonggi-do 16677 (KR)
(74) Representative: Appleyard Lees IP LLP
(86) International application number: PCT/KR2025/004403
(87) International publication number: WO 2025/249742

(57) **Abstract**

A light source apparatus may include: a substrate; a light emitting diode on the substrate; and an optical dome on the substrate and covering the light emitting diode. The substrate may include: a first electrode pad configured to receive a positive voltage; a second electrode pad configured to receive a negative voltage, the second electrode pad spaced apart from the first electrode pad in a first direction; a third electrode pad spaced apart from the first electrode pad in a second direction intersecting the first direction; and a fourth electrode pad spaced apart from the second electrode pad in the second direction.

## Description

### [Technical Field]

Some embodiments of the present disclosure relate to a light source apparatus and a manufacturing method thereof.

### [Background Art]

Generally, a display apparatus is a kind of an output apparatus that converts obtained or stored electrical information into visual information and displays the visual information to a user, and the display apparatus is used in various fields, such as a home or workplace.

The display apparatus may include a monitor apparatus connected to a personal computer (PC), a server computer, a portable computer device, a navigation terminal device, a general television apparatus, an Internet Protocol television (IPTV), a portable terminal device (e.g., a smart phone, a tablet PC, a personal digital assistant (PDA) or a cellular phone), various display apparatuses used to reproduce images (e.g., advertisements or movies in an industrial field), or various kinds of audio/video systems.

The display apparatus (whether a self-luminous display or a non-luminous display) may include a light source apparatus for converting electrical information into visual information, and the light source apparatus may include a plurality of light sources for independently emitting light. Each of the plurality of light sources may include a light emitting diode (LED) or an organic light emitting diode (OLED).

In particular, local dimming technology is applied to the light source apparatus (backlight unit) of the non-luminous display to improve the contrast ratio of the image. The plurality of light sources may be divided into a plurality of dimming blocks, and a driving element may control a driving current supplied to the light sources included in one or more dimming blocks.

The driving elements and light sources (e.g., light-emitting diodes) may be mounted on a substrate using surface mount technology (SMT).

Even when the number of the light emitting diodes mounted on the substrate is the same, the number of light-emitting diodes included in the dimming block may differ depending on the resolution, and wiring arrangements and the number of driving elements may also differ. Accordingly, various types of substrates are required depending on the resolution.

### [Disclosure]

### [Technical Problem]

The present disclosure is directed to providing a light source apparatus capable of implementing various resolutions using a single substrate, and a manufacturing method thereof.

The present disclosure is directed to providing a light source apparatus capable of reducing the types of substrates, thereby reducing the number of production lines and increasing the ease of managing the substrate, and a manufacturing method thereof.

The present disclosure is directed to providing a light source apparatus capable of increasing manufacturing efficiency of the light source apparatus, and a manufacturing method thereof.

### [Technical Solution]

According to some embodiments of the present disclosure, a light source apparatus having improved luminance and image quality compared to the same driving voltage, and a manufacturing method thereof may be provided.

According to some embodiments of the present disclosure, a light source apparatus may be provided and include: a substrate; at least one light emitting diode on the substrate; and an optical dome on the substrate and covering the at least one light emitting diode; wherein the substrate includes: a first electrode pad configured to receive a positive voltage; a second electrode pad configured to receive a negative voltage, the second electrode pad spaced apart from the first electrode pad in a first direction; a third electrode pad spaced apart from the first electrode pad in a second direction intersecting the first direction; and a fourth electrode pad spaced apart from the second electrode pad in the second direction.

According to some embodiments of the present disclosure, a method of manufacturing a light source apparatus may be provided and include: disposing a mask on a substrate; applying solder to the mask; separating the mask from the substrate; mounting at least one light emitting diode on the substrate; and covering the at least one light emitting diode with at least one optical dome, wherein the substrate includes: a first electrode pad configured to receive a positive voltage; a second electrode pad configured to receive a negative voltage, the second electrode pad spaced apart from the first electrode pad in a first direction; a third electrode pad spaced apart from the first electrode pad in a second direction intersecting the first direction; and a fourth electrode pad spaced apart from the second electrode pad in the second direction.

According to some embodiments of the present disclosure, a method of manufacturing a light source apparatus may be provided and include: providing at least one light emitting diode on the substrate; and providing an optical dome on the substrate and covering the at least one light emitting diode; wherein the substrate includes: a first electrode pad configured to receive a positive voltage; a second electrode pad configured to receive a negative voltage, the second electrode pad spaced apart from the first electrode pad in a first direction; a third electrode pad spaced apart from the first electrode pad in a second direction intersecting the first direction; and a fourth electrode pad spaced apart from the second electrode pad in the second direction.

Aspects of and technical problems solved by embodiments of the present disclosure are not limited to the above-mentioned aspects and technical problems, and other aspects of and technical problems solved by embodiments of the present disclosure not mentioned will be clearly understood by those skilled in the art to which the present disclosure belongs from the following description.

### [Description of Drawings]

FIG. 1 illustrates an example of an appearance of a display apparatus according to an embodiment.
FIG. 2 illustrates an example of a structure of the display apparatus according to an embodiment.
FIG. 3 illustrates an example of a structure of a display panel according to an embodiment.
FIG. 4 illustrates an example of a structure of a light source apparatus according to an embodiment.
FIG. 5 is a view illustrating a state in which a plurality of light sources is divided into a plurality of dimming blocks according to an embodiment.
FIG. 6 is a control block diagram of the display apparatus according to an embodiment.
FIG. 7 illustrates a connection structure of a dimming driver, a driving element, and a dimming block according to an embodiment.
FIG. 8 is a perspective view of an example of the light source apparatus according to an embodiment.
FIG. 9 is an exploded view of the light source apparatus shown in FIG. 8.
FIGS. 10A-D schematically illustrates a manufacturing process of the light source apparatus illustrated in FIG. 8.
FIG. 11 illustrates a cross-section taken along a line A-A' of FIG. 10D.
FIG. 12 is a perspective view of an example of a light source apparatus according to an embodiment.
FIG. 13 is an exploded view of the light source apparatus shown in FIG. 12.
FIGS. 14A-D schematically illustrates a manufacturing process of the light source apparatus of FIG. 12.
FIG. 15 illustrates a cross-section taken along a line B-B' of FIG. 14D.
FIG. 16 illustrates a cross-section taken along a line C-C' of FIG. 14D.
FIG. 17 is a perspective view of an example of a light source apparatus according to an embodiment.
FIG. 18 is an exploded view of the light source apparatus shown in FIG. 17.
FIGS. 19A-D schematically illustrates a manufacturing process of the light source apparatus shown in FIG. 17.
FIG. 20 illustrates a cross-section taken along a line D-D' shown in FIG. 19D.
FIG. 21 illustrates a cross-section taken along a line E-E' shown in FIG. 19D.
FIG. 22 illustrates an example of a manufacturing method of the light source apparatus according to an embodiment.

### [Modes of the Invention]

The example embodiments of and the terms used in the present disclosure are not intended to limit embodiments of the present disclosure to specific forms, and the present disclosure should be understood to include various modifications, equivalents, and/or alternatives to the corresponding embodiments.

In describing the drawings, similar reference numerals may be used to designate similar constituent elements.

A singular expression may include a plural expression unless otherwise indicated herein or clearly contradicted by context.

The expressions "A or B," "at least one of A or/and B," or "one or more of A or/and B," A, B or C," "at least one of A, B or/and C," or "one or more of A, B or/and C," and the like used herein may include any and all combinations of one or more of the associated listed items.

The term of "and / or" includes a plurality of combinations of relevant items or any one item among a plurality of relevant items.

Herein, the expressions "a first," "a second," "the first," "the second," etc., may simply be used to distinguish an element from other elements, but is not limited to another aspect (importance or order) of elements.

When an element (e.g., a first element) is referred to as being "(functionally or communicatively) coupled," or "connected" to another element (e.g., a second element), the first element may be connected to the second element, directly (e.g., wired), wirelessly, or through a third element.

In the present disclosure, the terms "including," "comprising," "having," and the like are used to specify features, numbers, steps, operations, elements, components, or combinations thereof, but do not preclude the presence or addition of one or more of the features, elements, steps, operations, elements, components, or combinations thereof.

When an element is said to be "connected," "coupled," "supported," or "contacted" with another element, this includes not only when elements are directly connected, coupled, supported, or contacted, but also when elements are indirectly connected, coupled, supported, or contacted through a third element.

Throughout the description, when an element is "on" another element, this includes not only when the element is in contact with the other element, but also when there is another element between the two elements.

Terms such as "unit," "module," "member," and "block" may be embodied as hardware or software. According to embodiments, a plurality of "unit," "module," "member," and "block" may be implemented as a single component or a single "unit," "module," "member," and "block" may include a plurality of components.

In the following description, terms such as "unit," "part," "block," "member," and "module" indicate a unit for processing at least one function or operation. For example, those terms may refer to at least one process processed by hardware such as a Field Programmable Gate Array (FPGA), Application Specific Integrated Circuit (ASIC), software stored in a memory, and/or a processor.

An identification code is used for the convenience of the description but is not intended to illustrate the order of each step. Each step may be implemented in the order different from the illustrated order unless the context clearly indicates otherwise

Reference will now be made in detail to non-limiting example embodiments of the present disclosure, examples of which are illustrated in the accompanying drawings.

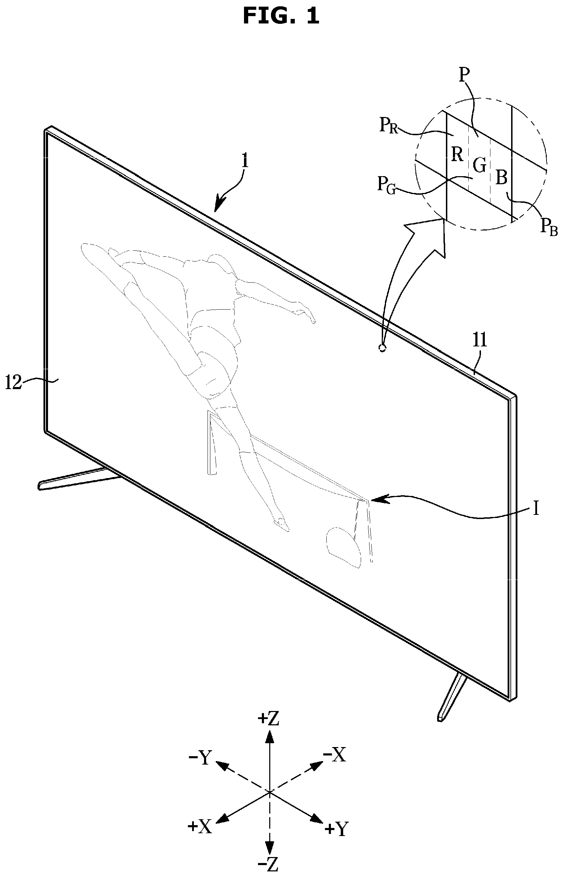

FIG. 1 illustrates an example of an appearance of a display apparatus according to an embodiment.

A display apparatus 1 may be a device that processes an image signal received from an outside and visually displays the processed image. Hereinafter, a case in which the display apparatus 1 is a television is provided as an example, but embodiments of the present disclosure are not limited thereto. For example, the display apparatus 1 may be implemented in various forms, such as a monitor, a portable multimedia device, and a portable communication device, and the display apparatus 1 is not limited in its shape as long as the display apparatus 1 is configured to visually display an image.

The display apparatus 1 may be a large format display (LFD) installed outdoors, such as a roof of a building or a bus stop. The outdoors is not limited to the outside of a building, and thus the display apparatus 1 according to an embodiment may be installed in any places where the display apparatus is accessed by people, even indoors, such as subway stations, shopping malls, movie theaters, companies, and stores.

The display apparatus 1 may receive content data including video data and audio data from various content sources, and output video and audio corresponding to the video data and the audio data. For example, the display apparatus 1 may receive content data through a broadcast reception antenna or cable, receive content data from a content playback device, or receive content data from a content providing server of a content provider.

As illustrated in FIG. 1, the display apparatus 1 may include a main body 11, and a screen 12 provided to display an image I. The display apparatus 1 may further include a supporter provided below the main body 11 to support the main body 11.

The main body 11 may form an appearance of the display apparatus 1, and a component configured to allow the display apparatus 1 to display the image I and to perform various functions may be provided in the main body 11. Although the main body 11 shown in FIG. 1 is in the form of a flat plate, the shape of the main body 11 is not limited thereto. For example, the main body 11 may have a curved plate shape.

The screen 12 may be formed on a front surface of the main body 11, and display the image I. For example, the screen 12 may display a still image or a moving image. Further, the screen 12 may display a two-dimensional (2D) plane image or a three-dimensional (3D) image using binocular parallax of the user.

A plurality of pixels P may be formed on the screen 12, and the image I displayed on the screen 12 may be formed by a combination of the lights emitted from the plurality of pixels P. For example, the image I may be formed on the screen 12 by combining light emitted from the plurality of pixels P as a mosaic.

Each of the plurality of pixels P may emit different brightness and different color of light. Each of the plurality of pixels P may include a self-luminous panel (e.g., a light-emitting diode panel) configured to directly emit light or a non-self-luminous panel (e.g., a liquid crystal panel) configured to transmit or block light emitted by a light source apparatus.

In order to emit light in the various colors, the plurality of pixels P may include sub-pixels, respectively.

The sub-pixels may include a red sub-pixel P_{R} emitting red light, a green sub-pixel P_{G} emitting green light, and a blue sub-pixel P_{B} emitting blue light. For example, the red light may be a light beam having a wavelength of approximately 620 nm (nanometers, one billionth of a meter) to 750 nm, the green light may be a light beam having a wavelength of approximately 495 nm to 570 nm, and the blue light may be a light beam having a wavelength of approximately 450 nm to 495 nm.

By combining the red light of the red sub-pixel P_{R}, the green light of the green sub-pixel P_{G}, and the blue light of the blue sub-pixel P_{B}, each of the plurality of pixels P may emit different brightness and different color of light.

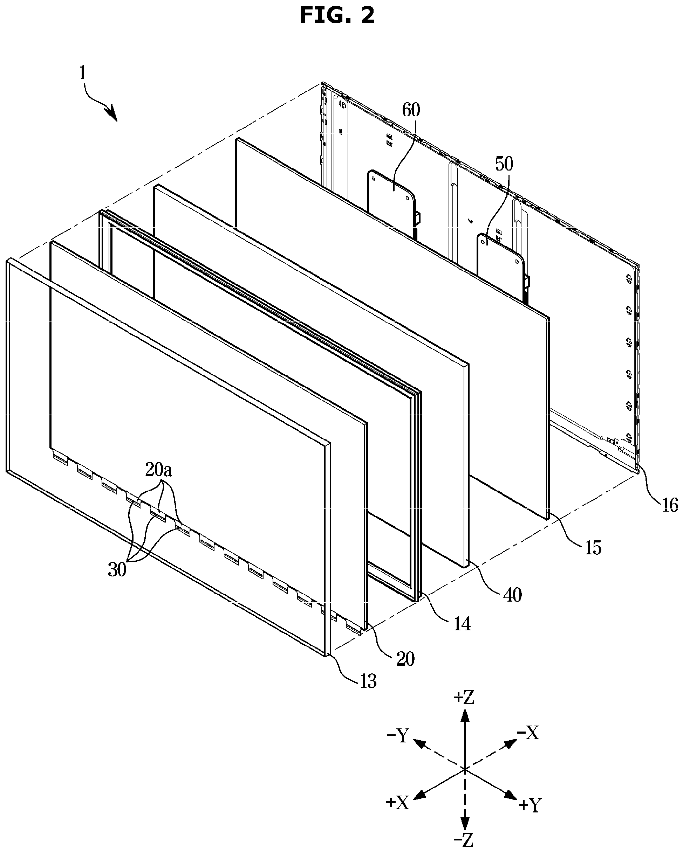

FIG. 2 illustrates an example of a structure of the display apparatus according to an embodiment.

As illustrated in FIG. 2, the display apparatus 1 may include various components configured to generate image I on the screen 12.

The display apparatus 1 may include a light source apparatus 40. The light source apparatus 40 may be configured to provide light to a display panel 20 described later.

For example, the light source apparatus 40 may be a surface light source. The light source apparatus 40 may include a point light source configured to emit monochromatic light or white light. The light source apparatus 40 may refract, reflect, and scatter light in order to convert light, which is emitted from the point light source, into uniform surface light. The light source apparatus 40 may refract, reflect, and scatter light emitted from the light source so as to emit uniform surface light.

A configuration of the light source apparatus 40 will be described in detail.

The display apparatus 1 may include the display panel 20. The display panel 20 may block or transmit light emitted from the light source apparatus 40. The display panel 20 may block or transmit light emitted from the light source apparatus 40 to form an image I. The display panel 20 may be provided in front (e.g., in the +X direction) of the light source apparatus 40.

A front surface of the display panel 20 may form the screen 12 of the display apparatus 1. The display panel 20 may form the plurality of pixels P. The plurality of pixels P may independently block or transmit light from the light source apparatus 40. Light transmitted by the plurality of pixels P may form an image I displayed on the screen 12.

A cable 20a configured to transmit image data to the display panel 20, and a display driver integrated circuit (DDI) (hereinafter referred to as panel driver 30) configured to process digital image data and output an analog image signal may be provided at one side of the display panel 20.

The cable 20a may electrically connect a control assembly 50 and/or a power assembly 60 to the panel driver 30. The cable 20a may electrically connect the panel driver 30 to the display panel 20. The cable 20a may include a flexible flat cable or a film cable that is bendable.

The panel driver 30 may receive image data and power from the control assembly 50 and/or the power assembly 60 through the cable 20a. The panel driver 30 may transmit the image data and a driving current to the display panel 20 through the cable 20a.

The cable 20a and the panel driver 30 may be integrally formed with each other. For example, the cable 20a and the panel driver 30 may be implemented as a film cable, a chip on film (COF), or a tape carrier package (TCP). In other words, the panel driver 30 may be arranged on the cable 20b. However, embodiments of the present disclosure are not limited thereto, and the panel driver 30 may be arranged on the display panel 20.

The display apparatus 1 may include the control assembly 50 configured to control an operation of the light source apparatus 40 and/or the display panel 20. The control assembly 50 may include a control circuit configured to control an operation of the display panel 20 and/or the light source apparatus 40. For example, the control circuit may process image data received from an external content source. For example, the control circuit may transmit image data to the display panel 20. For example, the control circuit may transmit dimming data to the light source apparatus 40.

The display apparatus 1 may include the power assembly 60 configured to supply power to the light source apparatus 40 and/or the display panel 20. The power assembly 60 may include a power circuit to supply power to the light source apparatus 40 and/or the display panel 20.

The control assembly 50 and the power assembly 60 may be implemented as a printed circuit board and various circuits mounted on the printed circuit board. For example, the control circuit may include a memory, a processor, and a control circuit board on which the memory and the processor are mounted. For example, the power circuit may include a capacitor, a coil, a resistance element, a processor, and a power circuit board on which the capacitor, the coil, the resistance element, and the processor are mounted.

The display apparatus 1 may include a chassis for supporting and fixing the display panel 20, the light source apparatus 40, the control assembly 50, and/or the power assembly 60. The main body 11 may include the chassis. For example, the chassis may include at least one from among a bezel 13, a frame middle mold 14, a bottom chassis 15, and a rear cover 16.

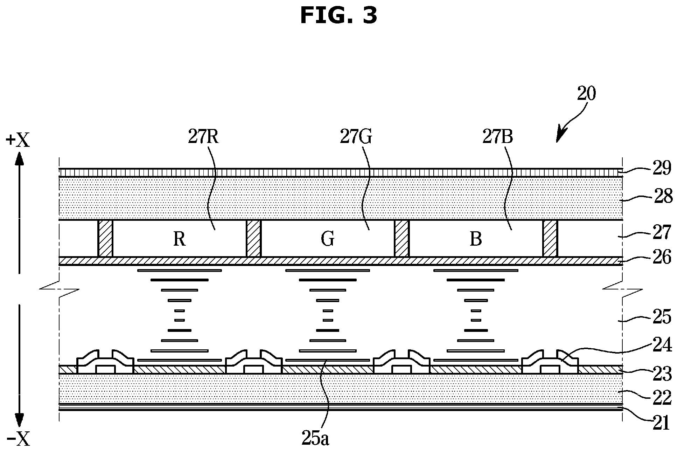

FIG. 3 illustrates an example of a structure of a display panel according to an embodiment.

For example, referring to FIG. 3, the display panel 20 may include a first polarizing film 21, a first transparent substrate 22, a pixel electrode 23, a thin film transistor 24, a liquid crystal layer 25, a common electrode 26, a color filter 27, a second transparent substrate 28, and a second polarizing film 29.

The first transparent substrate 22 and the second transparent substrate 28 may fixedly support the pixel electrode 23, the thin film transistor 24, the liquid crystal layer 25, the common electrode 26, and the color filter 27. The first transparent substrate 22 and the second transparent substrate 28 may be formed of tempered glass or transparent resin.

The first polarizing film 21 and the second polarizing film 29 may be provided on the outside of the first transparent substrate 22 and the second transparent substrate28.

Each of the first polarizing film 21 and the second polarizing film 29 may transmit a specific light beam and block other light beams. For example, a polarization direction of the light transmitted through the first polarizing film 21 and a polarization direction of the light transmitted through the second polarizing film 29 may be perpendicular to each other. As a result, in general, light may not pass through the first polarizing film 21 and the second polarizing film 29 at the same time.

The color filter 27 may be provided on an inner side of the second transparent substrate 28.

The color filter 27 may include a red filter 27R transmitting red light, a green filter 27G transmitting green light, and a blue filter 27B transmitting blue light. The red filter 27R, the green filter 27G, and the blue filter 27B may be disposed parallel to each other. A region, in which the color filter 27 is formed, may correspond to the pixel P described above. A region, in which the red filter 27R is formed, may correspond to the red sub-pixel P_{R}, a region, in which the green filter 27G is formed, may correspond to the green sub-pixel P_{G}, and a region, in which the blue filter 27B is formed, may correspond to the blue sub-pixel P_{B}.

The pixel electrode 23 may be provided on an inner side of the first transparent substrate 22, and the common electrode 26 may be provided on an inner side of the second transparent substrate 28.

The pixel electrode 23 and the common electrode 26 may be formed of a metal material through which electricity is conducted, and the pixel electrode 23 and the common electrode 26 may generate an electric field to change arrangement of liquid crystal molecules 25a forming the liquid crystal layer 25 to be described below.

The pixel electrode 23 and the common electrode 26 may be formed of a transparent material, and may transmit light incident from the outside. For example, the pixel electrode 23 and the common electrode 26 may include indium tin oxide (ITO), indium zinc oxide (IZO), silver nanowire (Ag nano wire), carbon nanotube (CNT), graphene, or poly (3,4-ethylenedioxythiophene) (PEDOT).

The thin film transistor (TFT) 24 may be provided at an inner side of the second transparent substrate 28.

The TFT 24 may transmit or block a current flowing through the pixel electrode 23. For example, an electric field may be formed or removed between the pixel electrode 23 and the common electrode 26 in response to turning on (e.g., closing) or turning off (e.g., opening) the TFT 24.

The TFT 24 may be formed of poly-silicon, and may be formed by semiconductor processes, such as lithography, deposition, and ion implantation.

The liquid crystal layer 25 may be formed between the pixel electrode 23 and the common electrode 26. The liquid crystal layer 25 may be filled with the liquid crystal molecules 25a.

Liquid crystals represent an intermediate state between a solid (e.g., crystal) and a liquid. Most of the liquid crystal materials may be organic compounds, and the molecular shape may be in the shape of an elongated rod, and the orientation of molecules may be in an irregular state in one direction, but in a regular state in other directions. As a result, the liquid crystal has both the fluidity of the liquid and the optical anisotropy of the crystal (solid).

Liquid crystals also exhibit optical properties according to changes in an electric field. For example, in the liquid crystal, the orientation of molecules forming the liquid crystal may change according to a change in an electric field. In response to an electric field being generated in the liquid crystal layer 25, the liquid crystal molecules 25a of the liquid crystal layer 25 may be disposed along the direction of the electric field. In response to the electric field not being generated in the liquid crystal layer 25, the liquid crystal molecules 25a may be disposed irregularly or disposed along an alignment layer. As a result, the optical properties of the liquid crystal layer 25 may vary depending on the presence or absence of the electric field passing through the liquid crystal layer 25.

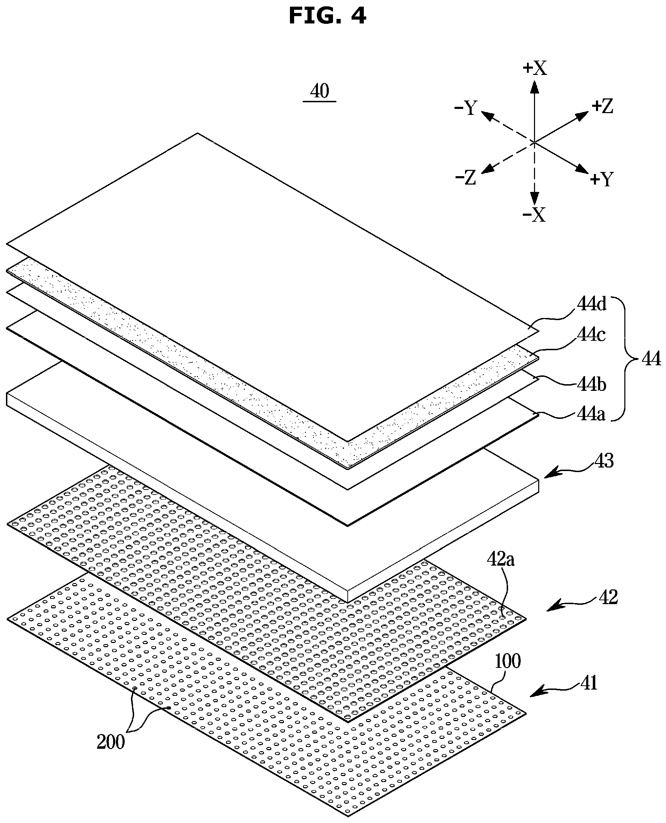

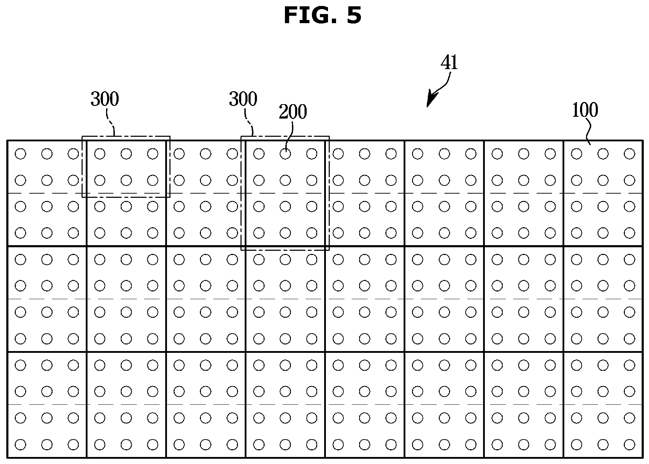

FIG. 4 illustrates an example of a structure of a light source apparatus according to an embodiment. FIG. 5 is a view illustrating a state in which a plurality of light sources is divided into a plurality of dimming blocks according to an embodiment.

Referring to FIG. 4, the light source apparatus 40 may include a light source module 41 configured to generate light. The light source apparatus 40 may include a reflective sheet 42 configured to reflect light. The light source apparatus 40 may include a diffuser plate 43 configured to uniformly diffuse light. The light source apparatus 40 may include an optical sheet 44 configured to improve a luminance of light that is emitted.

The light source module 41 may include a plurality of light sources 200 configured to emit light. The light source module 41 may include a substrate 100 provided to support/fix the plurality of light sources 200.

The plurality of light sources 200 may be disposed in a predetermined pattern to emit light with the uniform luminance. The plurality of light sources 200 may be disposed in such a way that a distance between one light source and light sources adjacent thereto is the same.

For example, as shown in FIG. 4, the plurality of light sources 200 may be disposed in rows and columns. Accordingly, the plurality of light sources 200 may be disposed such that a square is substantially formed by four adjacent light sources. In addition, any one light source may be disposed adjacent to four light sources, and a distance between one light source and four adjacent light sources may be substantially the same.

According to embodiments, the plurality of light sources 200 may be disposed such that an equilateral triangle is substantially formed by three adjacent light sources. In this case, one light source may be disposed adjacent to six light sources, and a distance between one light source and six adjacent light sources may be approximately the same.

However, the pattern in which the plurality of light sources 200 is disposed is not limited to the patterns described above, and the plurality of light sources 200 may be disposed in various patterns to emit light with the uniform luminance.

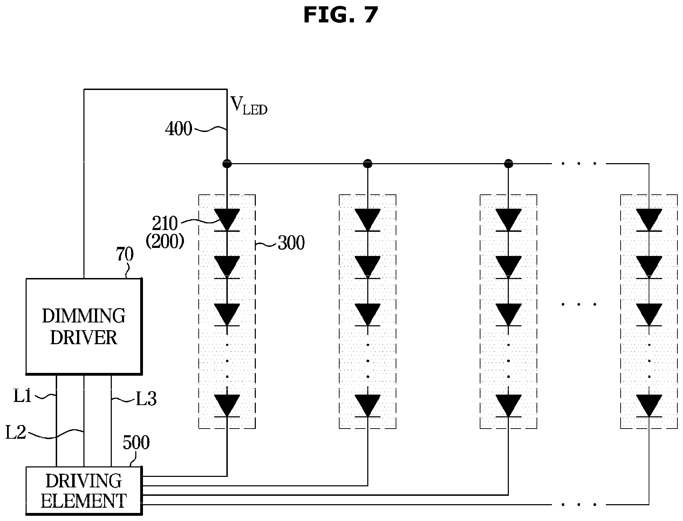

The light source 200 may employ an element configured to emit monochromatic light (light of a specific wavelength, e.g., blue light) or white light (e.g., light of a mixture of red light, green light, and blue light) in various directions by receiving power. For example, the light source 200 may include a light emitting diode (LED) 210 (refer to FIG. 7). The LED 210 may be implemented in various size and may include a mini-LED and/or micro-LED.

The substrate 100 may fix the plurality of light sources 200 to prevent a change in the position of the light source 200. Further, the substrate 100 may supply power, which is for the light source 200 to emit light, to the light source 200.

The substrate 100 may fix the plurality of light sources 200 and may be configured with synthetic resin or tempered glass or a printed circuit board (PCB) on which a conductive power supply line for supplying power to the light source 200 is formed.

Various types of wiring for supplying power to the light source 200 may be formed on the substrate 100. To form various types of wiring on the substrate 100, the printed circuit board may be formed with a plurality of layers.

The reflective sheet 42 may reflect light emitted from the plurality of light sources 200. For example, the reflective sheet 42 may reflect light emitted from the plurality of light sources 200 to the front side or in a direction close to the front side.

The reflective sheet 42 may include a plurality of through-holes 42a corresponding to each of the plurality of light sources 200 of the light source module 41. Each of the light source 200 of the light source module 41 may pass through the through-hole 42a and protrude to the front of the reflective sheet 42. For example, the plurality of light sources 200 of the light source module 41 may be inserted into the through-holes 42a formed on the reflective sheet 42. For example, the plurality of light sources 200 of the light source module 41 may be inserted into the through-holes 42a formed on the reflective sheet 42, respectively.

The plurality of light sources 200 may emit light in various directions in front of the reflective sheet 42. The light may be emitted not only toward the diffuser plate 43 from the light source 200, but also toward the reflective sheet 42 from the light source 200. The reflective sheet 42 may reflect light, which is emitted toward the reflective sheet 42, toward the diffuser plate 43.

Light emitted from the light source 200 may pass through various objects, such as the diffuser plate 43 and the optical sheet 44. Among incident light beams passing through the diffuser plate 43 and the optical sheet 44, some of the incident light beams may be reflected from the surfaces of the diffuser plate 43 and the optical sheet 44. The reflective sheet 42 may reflect light reflected by the diffuser plate 43 and the optical sheet 44.

The diffuser plate 43 may be provided in front (e.g., +X direction) of the light source module 41 and the reflective sheet 42, and may evenly distribute the light emitted from the light source 200 of the light source module 41.

Within the diffuser plate 43, the diffuser plate 43 may diffuse light emitted from the plurality of light sources 200 to remove unevenness in luminance. In other words, the diffuser plate 43 may uniformly emit light of the plurality of light sources 200 that was previously uneven.

The optical sheet 44 may include various sheets for improving luminance and luminance uniformity. For example, the optical sheet 44 may include at least one from among a diffusion sheet 44a, a first prism sheet 44b, a second prism sheet 44c, and a reflective polarizing sheet 44d.

The diffusion sheet 44a may diffuse light for the luminance uniformity. The light emitted from the light source 200 may be diffused by the diffuser plate 43 and may be diffused again by the diffusion sheet 44a included in the optical sheet 44.

The first prism sheet 44b and the second prism sheet 44c may increase the luminance by condensing light diffused by the diffusion sheet 44a. The first prism sheet 44b and the second prism sheet 44c may include a prism pattern in the shape of a triangular prism, and the prism pattern, which may be provided in plural, may be disposed adjacent to each other to form a plurality of strips.

The reflective polarizing sheet 44d may be a type of polarizing film and may transmit some of the incident light beams and reflect others for improving the luminance. For example, the reflective polarizing sheet 44d may transmit polarized light in the same direction as a predetermined polarization direction of the reflective polarizing sheet 44d, and may reflect polarized light in a direction different from the polarization direction of the reflective polarizing sheet 44d. In addition, the light reflected by the reflective polarizing sheet 44d may be recycled inside the light source apparatus 40, and thus the luminance of the display apparatus 1 may be improved by the light recycling.

The optical sheet 44 is not limited to the sheet or film shown in FIG. 4, and may include more various sheets, such as a protective sheet, or films.

The light source apparatus 40 may include the plurality of light sources 200 and may output surface light by diffusing light emitted from the plurality of light sources 200. The display panel 20 may include the plurality of pixels and control the plurality of pixels to allow each of the plurality of pixels to pass light or block light. An image I may be formed by light passing through each of the plurality of pixels.

At this time, the display apparatus 1 may perform local dimming to vary the brightness of light in each region of the light source apparatus 40 in conjunction with the output image so as to improve power consumption while increasing the contrast ratio.

For example, the display apparatus 1 may reduce the brightness of the light source 200 of the light source apparatus 40 corresponding to a dark portion of the image in order to make the dark portion of the image darker, and may increase the brightness of the light source 200 of the light source apparatus 40 corresponding to a bright portion of the image in order to make the bright portion of the image brighter. As a result, the contrast ratio or brightness ratio of the image may be improved.

The light source apparatus 40 of the display apparatus 1 may be divided into a plurality of blocks, and the display apparatus 1 may independently control the current for each block according to an input image. The image transmission of the display apparatus 1 may be performed by a method of local dimming driving for each frame, and driving of the current may be controlled according to the number of blocks of the light sources 200 divided in the light source apparatus 40.

As a result, the display apparatus 1 may effectively improve the contrast ratio by reducing the supply current to the dimming block corresponding to the dark region of the input image and increasing the supply current to the dimming block corresponding to the bright region of the input image.

For the local dimming, the plurality of light sources 200 included in the light source apparatus 40 may be classified into a plurality of dimming blocks 300.

According to various embodiments, k light sources 200 may be classified into n dimming blocks or m dimming blocks (k, n, m are natural numbers). For example, k light sources 200 may be classified into n dimming blocks, each of which includes k/n light sources 200. k/n means a value obtained by dividing k by n. As another example, k light sources 200 may be classified into m dimming blocks, each of which includes k/m light sources 200. k/m means a value obtained by dividing k by m. n and m may be different from each other, and k may be a multiple of n and m.

For example, when k is 120, n may be 20, m may be 10, and 120 light sources 200 may be classified into 20 dimming blocks, each of which includes 6 light sources 200, or into 10 dimming blocks, each of which includes 12 light sources 200.

k/n or k/m light sources 200 included in each dimming block may be arranged in a matrix form. The matrix, in which k/n or k/m light sources 200 included in each dimming block are arranged, may have the same number of rows or the same number of columns.

According to various embodiments, k/n may be 9 or less, and k/m may be 12 or more. That is, the plurality of light sources 200 may be divided into dimming blocks, each of which includes 9 or less LEDs, or into dimming blocks, each of which includes 12 or more LEDs.

Referring to FIG. 5, each of the plurality of dimming blocks 300 may include at least one light source 200. The light source apparatus 40 may supply the same driving current to the light sources 200 belonging to the same dimming block 300, and the light sources 200 belonging to the same dimming block 300 may emit light of the same brightness.

In addition, the light source apparatus 40 may supply different driving currents to the light sources 200 belonging to different dimming blocks 300 according to dimming data, and the light sources 200 belonging to different dimming blocks 300 may emit light of different brightness.

Each of the plurality of dimming blocks 300 may include N*M light sources 200 arranged in an N*M matrix form (N and M are natural numbers). An N*M matrix means a matrix having N rows and M columns.

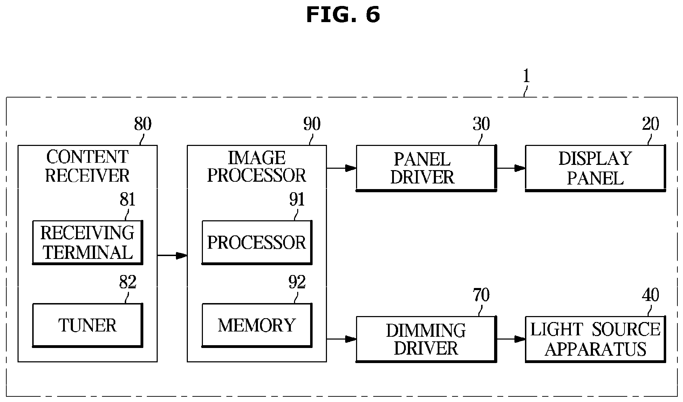

FIG. 6 is a control block diagram of the display apparatus according to an embodiment.

Referring to FIG. 6, the display apparatus 1 may include a content receiver 80, an image processor 90, the panel driver 30, the display panel 20, a dimming driver 70, and the light source apparatus 40.

The content receiver 80 may include a receiving terminal 81 and a tuner 82 that receive a content including video signals and/or audio signals from content sources.

The receiving terminal 81 may receive video signals and audio signals from content sources through a cable. The receiving terminal 81 may include a component (e.g., YPbPr/RGB) terminal, a composite video blanking and sync (CVBS) terminal, an audio terminal, a High-Definition Multimedia Interface (HDMI) terminal, a Universal Serial Bus (USB) terminal, etc.

The tuner 82 may receive a broadcast signal from a broadcast reception antenna or a wired cable. Further, the tuner 82 may extract a broadcast signal of a channel selected by a user from broadcast signals. For example, the tuner 82 may transmit a broadcast signal having a frequency corresponding to a channel selected by a user among a plurality of broadcast signals received through the broadcast reception antenna or the wired cable, and block a broadcast signal having a different frequency.

As mentioned above, the content receiver 80 may receive video signals and audio signals from content sources through the receiving terminal 81 and/or the tuner 82. The content receiver 80 may output video signals and/or audio signals, which are received through the receiving terminal 81 and/or the tuner 82, to the image processor 90.

The image processor 90 may include a processor 91 configured to process image data, and a memory 92 configured to memorize/store programs and data for processing image data.

The memory 92 may store programs and data for processing video signals and/or audio signals. Further, the memory 92 may temporarily store data that is generated in processing video signals and/or audio signals.

The memory 92 may include a non-volatile memory such as Read Only Memory (ROM) and flash memory, and a volatile memory such as Static Random Access Memory (SRAM) and Dynamic Random Access Memory (DRAM).

The processor 91 may receive video signals and/or audio signals from the content receiver 80. The processor 91 may decode the video signal into image data. The processor 91 may generate dimming data from the image data. Further, the processor 91 may output image data and dimming data to the panel driver 30 and the dimming driver 70, respectively.

As mentioned above, the image processor 90 may generate image data and dimming data from the video signal obtained by the content receiver 80. Further, the image processor 90 may transmit image data and dimming data to the display panel 20 and the light source apparatus 40, respectively.

Image data may include information about the intensity of light transmitted by each of the plurality of pixels (or a plurality of sub-pixels) included in the display panel 20. The image data may be provided to the display panel 20 through the panel driver 30.

The display panel 20 may include the plurality of pixels configured to transmit or block light, and the plurality of pixels may be arranged in a matrix form. In other words, the plurality of pixels may be arranged in a plurality of rows and a plurality of columns.

The panel driver 30 may receive image data from the image processor 90. The panel driver 30 may drive the display panel 20 according to the image data. In other words, the panel driver 30 may convert image data, which may be a digital signal (hereinafter referred to as "digital image data"), into an analog image signal, which may be an analog voltage signal. The panel driver 30 may provide the analog image signal to the display panel 20. The optical properties (e.g., light transmittance) of the plurality of pixels included in the display panel 20 may change according to the analog image signal.

The panel driver 30 may include a timing controller, a data driver, a scan driver, etc.

The timing controller may receive image data from the image processor 90. The timing controller may output image data and a drive control signal to the data driver and the scan driver. The drive control signal may include a scan control signal and a data control signal. The scan control signal and the data control signal may be used to control the operation of the scan driver and the data driver, respectively.

The scan driver may receive a scan control signal from the timing controller. The scan driver may activate the input of any one row among the plurality of rows in the display panel 20 according to the scan control signal. In other words, the scan driver may convert a pixel, which is included in one row among the plurality of pixels arranged in the plurality of rows and the plurality of columns, into a state capable of receiving an analog image signal. At this time, pixels other than pixels in which the input is activated by the scan driver may not receive the analog image signal.

The data driver may receive image data and data control signals from the timing controller. The data driver may output image data to the display panel 20 according to the data control signal. For example, the data driver may receive digital image data from the timing controller. The data driver may convert digital image data into analog image signals. Further, the data driver may provide an analog image signal to pixels included in any one input-activated row by the scan driver. At this time, pixels in which the input is activated by the scan driver may receive analog image signals. The optical properties (e.g., light transmittance) of input-activated pixels change according to the received analog image signal.

As mentioned above, the panel driver 30 may drive the display panel 20 according to image data. Accordingly, an image corresponding to the image data may be displayed on the display panel 20.

The dimming driver 70 may control the light source apparatus 40.

The dimming data may include information about the intensity of light emitted by each of the plurality of light sources 200 (or plurality of dimming blocks 300) included in the light source apparatus 40. The dimming data may be provided to the light source apparatus 40 through the dimming driver 70.

The light source apparatus 40 may turn off the plurality of light sources corresponding to the dark portion of the image, so as to make the dark portion of the image darker. Accordingly, as the dark portion of the image becomes darker, the contrast ratio of the image may be improved.

Hereinafter an operation, in which the light source apparatus 40 controls the plurality of light sources to emit light in a region corresponding to the bright portion of the image and controls the plurality of light sources to not emit light in a region corresponding to the dark portion of the image, will be referred to as "local dimming."

For the local dimming, the plurality of light sources 200 included in the light source apparatus 40 may be divided into the plurality of dimming blocks 300 as shown in FIG. 5. A total of 48 dimming blocks in 6 rows and 8 columns are shown in FIG. 5, but the number and arrangement of dimming blocks are not limited to those shown in FIG. 5.

Each of the plurality of dimming blocks 300 may include at least one light source 200. The light source apparatus 40 may supply the same driving current to light sources belonging to the same dimming block 300, and the light sources 200 belonging to the same dimming block 30 may emit light of the same brightness. For example, light sources 200 belonging to the same dimming block 300 may be connected to each other in series, and thus the same driving current may be supplied to the light sources 200 belonging to the same dimming block 300.

Further, the light source apparatus 40 may further include a plurality of driving elements 500 (refer to FIG. 7) configured to control a driving current supplied to light sources included in each of the plurality of dimming blocks 300. The driving elements 500 may each be provided to correspond to at least one dimming block 300. In other words, the driving elements 500 may drive the dimming blocks 300.

The driving element 500 may include an integrated circuit chip for controlling the driving current applied to at least one dimming block 300.

Because the light sources included in the dimming block are connected to each other in series, the light sources included in the dimming block may operate as one unit and may form a light source block as one unit.

Hereinafter "supplying driving current to the dimming block" may have the same meaning as "supplying driving current to the light sources included in the dimming block."

As mentioned above, the image processor 90 may provide dimming data for the local dimming to the light source apparatus 40. The dimming data may include information about the luminance of each of the plurality of dimming blocks 300. For example, the dimming data may include information about the intensity of light output from light sources 200 included in each of the plurality of dimming blocks 300.

The image processor 90 may obtain dimming data from image data.

The image processor 90 may convert image data into dimming data in various ways. For example, the image processor 90 may divide the image I based on image data into a plurality of image blocks. The number of the plurality of image blocks may be equal to the number of the plurality of dimming blocks 300, and each of the plurality of image blocks may correspond to the plurality of dimming blocks 300.

The image processor 90 may obtain a luminance value of the plurality of dimming blocks 300 from the image data of the plurality of image blocks. Further, the image processor 90 may generate dimming data by combining the luminance values of the plurality of dimming blocks 300.

For example, the image processor 90 may obtain a luminance value of each of the plurality of dimming blocks 300 based on a maximum value among luminance values of pixels included in each image block.

A single image block may include a plurality of pixels, and image data of the single image block may include image data of a plurality of pixels (e.g., red data, green data, blue data, etc.). The image processor 90 may calculate the luminance value of each pixel based on the image data of each pixel.

The image processor 90 may set a maximum value among the luminance values of each pixel included in the image block as a luminance value of the dimming block corresponding to the image block. For example, the image processor 90 may set a maximum value among luminance values of pixels included in a i^{th} image block as a luminance value of a i^{th} dimming block, and set a maximum value among luminance values of pixels included in a j^{th} image block as a luminance value of a j^{th} dimming block.

The image processor 90 may generate dimming data by combining the luminance values of the plurality of dimming blocks 300.

The dimming driver 70 may receive dimming data from the image processor 90. The dimming driver 70 may drive the light source apparatus 40 according to the dimming data. The dimming data may include information about the luminance of each of the plurality of dimming blocks 300 or information about the brightness of light sources 200 included in each of the plurality of dimming blocks 300.

The dimming driver 70 may convert dimming data, which may be a digital voltage signal, into analog driving current.

The dimming driver 70 may sequentially provide an analog dimming signal to the driving elements 500 corresponding to each of the dimming blocks 300 in an activematrix method.

The plurality of dimming blocks 300 may be divided into a plurality of groups. A driving current may be supplied simultaneously to dimming blocks 300 belonging to the same group, and a driving current may be supplied sequentially at different times to dimming blocks 300 belonging to different groups. The dimming driver 70 may activate dimming blocks 300 belonging to one of the plurality of groups and provide an analog dimming signal to the activated dimming blocks. Thereafter, the dimming driver 70 may activate dimming blocks 300 belonging to different groups and provide an analog dimming signal to the activated dimming blocks. For example, dimming blocks 300 located in the same row may belong to the same group, and dimming blocks 300 located in different rows may belong to different groups, but the group classification method is not limited thereto. The dimming driver 70 may activate dimming blocks 300 belonging to one group and provide an analog dimming signal to the activated dimming blocks. Thereafter, the dimming driver 70 may activate the input of dimming blocks 300 belonging to another row and provide an analog dimming signal to the dimming blocks 300 in which the input is activated.

The plurality of dimming blocks 300 may be divided into a plurality of groups, each of which is connected to the same driving element 500. For example, the plurality of dimming blocks 300 may be divided into a first group of dimming blocks 300 connected to a first driving element, and a second group of dimming blocks 300 connected to a second driving element.

A drive circuit of each of the dimming blocks 300 may provide an analog driving current corresponding to an analog dimming signal to the light source module 41. The light sources 200 included in the light source apparatus 40 may emit light by the analog driving current. According to dimming data, light sources 200 belonging to the same dimming block 300 may emit light of the same intensity. Further, according to dimming data, light sources 200 belonging to different dimming blocks 300 may emit light of different intensities.

FIG. 7 illustrates a connection structure of a dimming driver, a driving element, and a dimming block according to an embodiment.

Referring to FIG. 7, each of the plurality of dimming blocks 300 may include the plurality of light sources 200 connected in series. For example, each of the plurality of dimming blocks 300 may include a plurality of LEDs 210 connected in series.

For example, when one dimming block 300 includes a first LED, a second LED, a third LED, and a fourth LED, an anode of the first LED may be connected to a power line, a cathode of the first LED may be connected to an anode of the second LED, a cathode of the second LED may be connected to an anode of the third LED, a cathode of the third LED may be connected to an anode of the fourth LED, and a cathode of the fourth LED may be connected to the driving element 500.

That is, among the plurality of light sources 200 connected in series and belonging to one dimming block 300, a light source 200, which is the first in the series connection, may be connected to a power line 400 and receive power (driving voltage V_{LED}), and a light source 200, which is the last in the series connection, may be connected to the driving element 500.

While being input-activated by the dimming driver 70, the driving element 500 may receive an analog dimming signal from the dimming driver 70 and store the received analog dimming signal. Further, while being input-inactivated, the plurality of driving elements 500 may supply a driving current corresponding to the stored analog dimming signal to the plurality of LEDs 210.

The driving element 500 may control the driving current supplied to each of the plurality of dimming blocks 300 while the driving voltage V_{LED} is applied to the plurality of dimming blocks 300.

For this, the display apparatus 1 may include a scan line L1 for providing a scan signal to the plurality of driving elements 500 and data lines L2 and L3 for providing analog dimming signals to the plurality of driving elements 500.

Further, the display apparatus 1 may include the power line 400 for providing driving voltage to the plurality of driving elements 500.

The scan line L1, the data lines L2 and L3, and the power line 400 may be formed on the substrate 100.

The plurality of driving elements 500 may include circuits of various topologies to implement the active matrix driving.

For example, each of the plurality of driving elements 500 may include a circuit of a one capacitor two transistor (1C2T) topology. However, the circuit structure of the driving element 500 is not limited thereto. For example, the driving element 500 may include a three transistor one capacitor (3T1C) topology circuit in which a transistor is added to correct the body effect of the driving transistor.

The driving element 500 may be provided as a single chip with an integrated drive circuit. In other words, the drive circuit may be integrated into one semiconductor chip.

The dimming driver 70 may transmit dimming data corresponding to the input image to the plurality of driving elements 500 through the data lines L2 and L3.

The dimming driver 70 may transmit a timing signal corresponding to a light emission timing of the plurality of dimming blocks 300 to the plurality of driving elements 500 through the scan line L1.

The plurality of driving elements 500 may control the driving current supplied to each of the plurality of dimming blocks 300 based on dimming data and timing signals.

For the local dimming, the display apparatus 1 may include more dimming blocks 300, driving elements 500, data lines L2 and L3, and scan lines L1 and power lines 400 which connect the dimming blocks 300 and the driving elements 500, in comparison with those shown in FIG. 7. Various lines may be formed on the substrate 100, and embodiments of the present disclosure are not limited to those illustrated in FIG. 7.

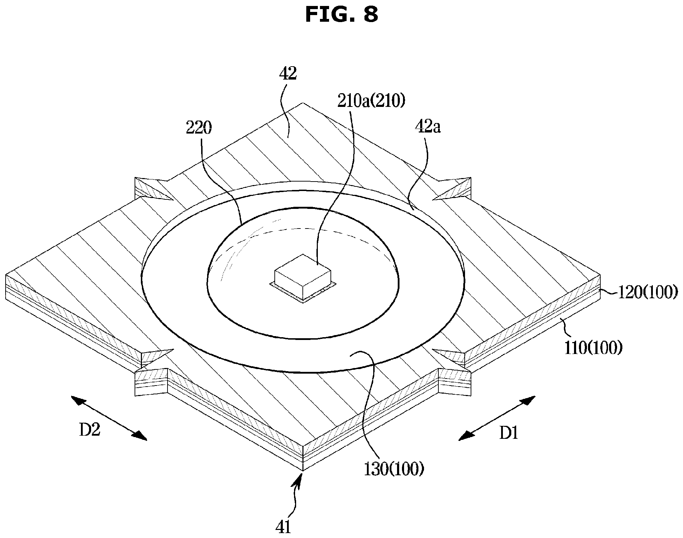

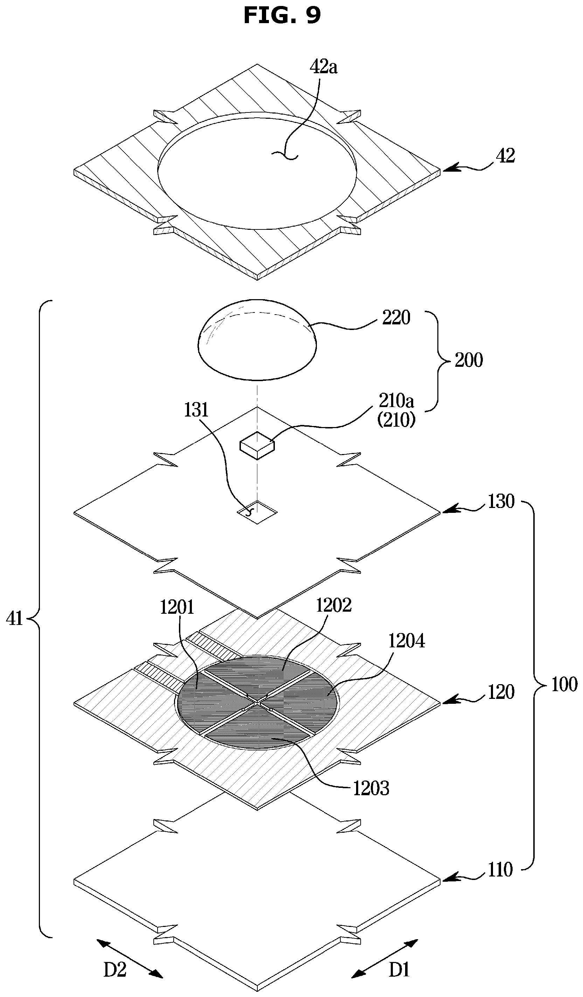

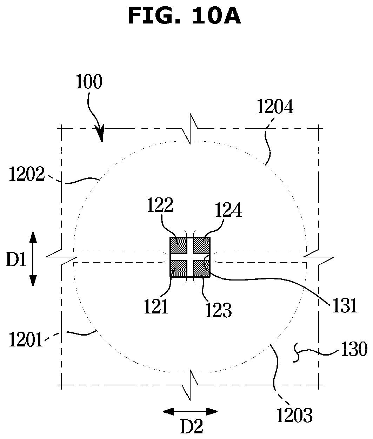

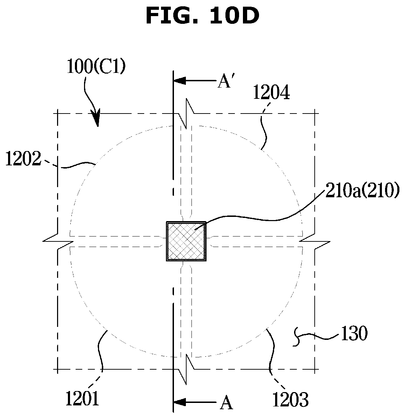

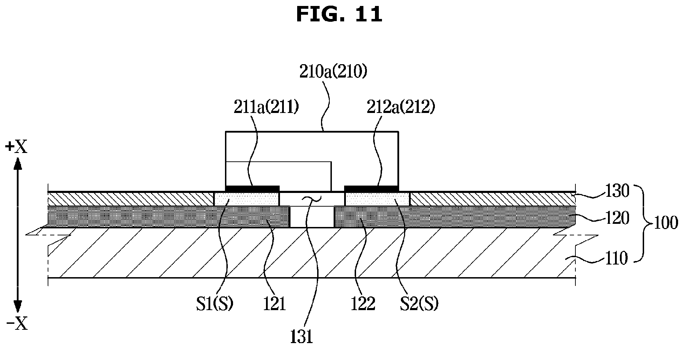

FIG. 8 is a perspective view of an example of the light source apparatus according to an embodiment. FIG. 9 is an exploded view of the light source apparatus shown in FIG. 8. FIGS. 10A-D schematically illustrates a manufacturing process of the light source apparatus illustrated in FIG. 8. FIG. 11 illustrates a cross-section taken along a line A-A' of FIG. 10D.

Referring to FIGS. 8 and 9, the light source apparatus 40 may include the light source module 41 and the reflective sheet 42.

The light source module 41 may include the plurality of light sources 200. The light source 200 may pass through the through-hole 42a of the reflective sheet 42 and protrude from the reflective sheet 42. The light source 200 and a portion of the substrate 100 may be exposed through the through-hole 42a.

Each of the plurality of light sources 200 may include the at least one LED 210 and an optical dome 220.

Hereinafter, a LED for implementing a first resolution (e.g., 8K) may be referred to/expressed as a LED 210a, and a LED for implementing a second resolution (e.g., 4K) that is relatively lower than the first resolution may be referred to/expressed as a LED 210b. For example, the LED 210a may have a first size, and the LED 210b may have a second size smaller than the first size. For example, the LED 210a may have a size of approximately 500 µm x 500 µm, and the LED 210b may have a size of approximately 400 µm x 220 µm, but the sizes of each of the LED 210a and the LED 210b are not limited to the examples described above. It should be understood that the size of the LED may vary depending on various factors such as the configuration of the light source apparatus 40, the type of the display apparatus 1, and the like. In addition, a LED that is commonly used regardless of the resolution may be referred to/expressed as a LED 210. That is, the description of the LED 210 may be a description common to both the LED 210a and the LED 210b.

The LED 210 may emit light. The LED 210 may include a P-type semiconductor and an N-type semiconductor for emitting light by recombination of holes and electrons. In addition, the LED 210 may include a pair of electrodes 211 and 212 (refer to FIG. 11) for supplying holes and electrons to the P-type semiconductor and the N-type semiconductor, respectively. For example, the LED 210 may include an anode (e.g., the electrode 211) and a cathode (e.g., the electrode 212).

The LED 210 may convert electrical energy into light energy. In other words, the LED 210 may emit light having a maximum intensity at a predetermined wavelength to which power is supplied.

The LED 210 may be provided to be mountable on the substrate 100. For example, the LED 210 may be directly attached to the substrate 100 in a chip on board (COB) manner. In other words, the light source 200 may include a LED 210 in which a light emitting diode chip or light emitting diode die is directly attached to the substrate 100 without separate packaging.

To reduce the size of the light source 200, the light source module 41 may be manufactured in which a LED 210, that may be a flip chip type LED, is attached to the substrate 100 in a chip-on-board manner.

The optical dome 220 may cover the LED 210. The optical dome 220 may be arranged on the substrate 100 to cover the LED 210.

The optical dome 220 may prevent or suppress damages to the LED 210 caused by an external mechanical action and/or damage to the LED 210 caused by a chemical action.

The optical dome 220 may be spaced apart from the reflective sheet 42. For example, the optical dome 220 may be smaller than the through-hole 42a.

The optical dome 220 may have a dome shape formed in such a way that a sphere is cut into a surface not including the center thereof, or may have a hemispherical shape in such a way that a sphere is cut into a surface including the center thereof. A vertical cross section of the optical dome 220 may be a bow shape or a semicircle shape.

The optical dome 220 may be formed of silicone or epoxy resin. For example, the molten silicon or epoxy resin may be discharged onto the LED 210 through a nozzle, and the discharged silicon or epoxy resin may be cured, thereby forming the optical dome 220. The shape of the optical dome 220 may vary depending on the viscosity of the liquid silicone or epoxy resin.

The optical dome 220 may be optically transparent or translucent. Light emitted from the LED 210 may be emitted to the outside by passing through the optical dome 220.

In this case, the optical dome 220 may refract light like a lens. For example, light emitted from the LED 210 may be refracted by the optical dome 220 and thus may be dispersed.

As mentioned above, the optical dome 220 may disperse light emitted from the LED 210 as well as protecting the light-emitting diode 210 from external mechanical and/or chemical or electrical actions.

The substrate 100 may include a base 110 that is insulative, a conduction layer 120 that is conductive, and a protection layer 130. The conduction layer 120 may be disposed between the base 110 and the protection layer 130. The base 110 and the conduction layer 120 may be alternately laminated.

A dielectric of the base 110 may insulate between the lines or patterns of the conduction layer 120. The base 110 may be composed of a dielectric for electrical insulation, such as, FR-4. The base 110 may be referred to as an insulation layer.

The conduction layer 120 may be disposed on the base 110. The conduction layer 120 may be formed on one side of the base 110. The conduction layer 120 may cover the base 110. Meanwhile, in the present disclosure, the meaning that one component "covers" another component may include not only that one component completely covers the other component, but also that one component covers a portion of the other component.

A line or pattern through which power and/or electrical signals pass may be formed in the conduction layer 120. The conduction layer 120 may be composed of various materials having electrical conductivity. For example, the conduction layer 120 may be composed of various metal materials such as copper (Cu), tin (Sn), aluminum (Al), or an alloy thereof.

The substrate 100 may include electrode patterns (e.g., a first electrode pattern 1201, a second electrode pattern 1202, a third electrode pattern 1203 and/or the fourth electrode pattern 1204) for supplying electrical signals and/or power to the LED 210. The electrode patterns (e.g., the first electrode pattern 1201, the second electrode pattern 1202, the third electrode pattern 1203 and/or the fourth electrode pattern 1204) may be electrically connected to the LED 210. For example, at least a portion of the electrode patterns (e.g., the first electrode pattern 1201, the second electrode pattern 1202, the third electrode pattern 1203 and/or the fourth electrode pattern 1204) may be exposed to the outside of the substrate 100 to form electrode pads (e.g., a first electrode pad 121, a second electrode pad 122, a third electrode pad 123 and/or a fourth electrode pad 124) (refer to FIG. 10A), and the LED 210 may be electrically connected to the electrode pads (e.g., the first electrode pad 121, the second electrode pad 122, the third electrode pad 123 and/or the fourth electrode pad 124). The LED 210 may be in electrical contact with the electrode pads (e.g., the first electrode pad 121, the second electrode pad 122, the third electrode pad 123 and/or the fourth electrode pad 124). The electrode patterns (e.g., the first electrode pattern 1201, the second electrode pattern 1202, the third electrode pattern 1203 and/or the fourth electrode pattern 1204) may be formed on the conduction layer 120. The electrode pads (e.g., the first electrode pad 121, the second electrode pad 122, the third electrode pad 123 and/or the fourth electrode pad 124) may be implemented by lines or patterns formed on the conduction layer 120. A detailed description of the electrode pads (e.g., the first electrode pad 121, the second electrode pad 122, the third electrode pad 123 and/or the fourth electrode pad 124) will be provided later.

The protection layer 130 may be provided to prevent or suppress damage to the substrate 100 due to external impact, damage due to chemical action (e.g., corrosion, etc.), and/or damage due to optical action. The protection layer 130 may be provided at one side of the substrate 100 facing the light source 200. The protection layer 130 may include a photo solder resist (PSR).

The protection layer 130 may be disposed on the conduction layer 120. The protection layer 130 may be formed on one side of the conduction layer 120.

The protection layer 130 may cover the conduction layer 120. A portion of the conduction layer 120 that is not covered by the protection layer 130 may be provided as the electrode pads (e.g., the first electrode pad 121, the second electrode pad 122, the third electrode pad 123 and/or the fourth electrode pad 124). The protection layer 130 may include an exposed portion 131 provided to expose a portion of the conduction layer 120. At this time, the electrode pads (e.g., the first electrode pad 121, the second electrode pad 122, the third electrode pad 123 and/or the fourth electrode pad 124) may be formed as the conduction layer 120 is exposed through the exposed portion 131. For example, the protection layer 130 may be formed as PSR ink is coated (or applied) on the conduction layer 120, and the exposed portion 131 may be formed as PSR ink is not coated (or applied) on the conduction layer 120. The exposed portion 131 may be a window (e.g., a hole).

For example, a portion of a first electrode pattern 1201 exposed through the exposed portion 131 may be provided as a first electrode pad 121. A portion of the first electrode pattern 1201 exposed to the outside of the substrate 100 through the exposed portion 131 may form the first electrode pad 121.

For example, a portion of a second electrode pattern 1202 exposed through the exposed portion 131 may be provided as a second electrode pad 122. A portion of the second electrode pattern 1202 exposed to the outside of the substrate 100 through the exposed portion 131 may form the second electrode pad 122.

For example, a portion of a third electrode pattern 1203 exposed through the exposed portion 131 may be provided as a third electrode pad 123. A portion of the third electrode pattern 1203 exposed to the outside of the substrate 100 through the exposed portion 131 may form the third electrode pad 123.

For example, a portion of a fourth electrode pattern 1204 exposed through the exposed portion 131 may be provided as a fourth electrode pad 124. A portion of the fourth electrode pattern 1204 exposed to the outside of the substrate 100 through the exposed portion 131 may form the fourth electrode pad 124.

FIG. 10A illustrates the substrate 100. The substrate 100 may include at least one electrode pad (e.g., the first electrode pad 121, the second electrode pad 122, the third electrode pad 123 and/or the fourth electrode pad 124). The electrode pads (e.g., the first electrode pad 121, the second electrode pad 122, the third electrode pad 123 and/or the fourth electrode pad 124) may be electrically connected to the LED 210 mounted on the substrate 100 and may transmit electrical signals, etc. to the LED 210.

The substrate 100 may include the first electrode pad 121 to which a positive voltage is applied. The substrate 100 may include the second electrode pad 122 to which a negative voltage is applied. The second electrode pad 122 may be spaced apart from the first electrode pad 121 with respect to a first direction D1. The substrate 100 may include the third electrode pad 123 spaced apart from the first electrode pad 121 with respect to a second direction D2. The second direction D2 may be a direction intersecting the first direction D1. The second direction D2 may be a direction perpendicular to the first direction D1. The substrate 100 may include the fourth electrode pad 124 spaced apart from the second electrode pad 122 with respect to the second direction D2.

The first electrode pad 121 and the second electrode pad 122 may be arranged along the first direction D1. The first electrode pad 121 and the third electrode pad 123 may be arranged along the second direction D2. The second electrode pad 122 and the fourth electrode pad 124 may be arranged along the second direction D2. The first electrode pad 121 and the fourth electrode pad 124 may be arranged in a diagonal direction with respect to the first direction D1 and the second direction D2. The second electrode pad 122 and the third electrode pad 123 may be arranged in the diagonal direction.

A portion of the plurality of electrode pads (e.g., the first electrode pad 121, the second electrode pad 122, the third electrode pad 123 and/or the fourth electrode pad 124) may be formed integrally. As will be described later, the third electrode pad 123 and the fourth electrode pad 124 may be formed integrally.

Meanwhile, a mask 600 may be provided to form a solder portion S on the substrate 100. The mask 600 may include a substrate body for covering the substrate 100, and an opening formed to penetrate the substrate body. When the mask 600 is disposed on the substrate 100 and solder is applied, and then the mask 600 is separated from the substrate 100, the solder may remain only in a region of the substrate 100 corresponding to the opening of the mask 600. At this time, the solder remaining on the substrate 100 may be referred to as a solder portion S. The solder portion S may have electrical conductivity. The solder portion S may be configured to electrically connect the electrode pads (e.g., the first electrode pad 121, the second electrode pad 122, the third electrode pad 123 and/or the fourth electrode pad 124) of the substrate 100 and the electrodes 211 and/or 212 of the LED 210.

The mask 600 may be provided in various types (e.g., e.g., a first mask 600a, a second mask 600b, a third mask 600c, etc.). The type of the mask 600 may vary depending on the shape, number, and/or arrangement of the openings formed in the mask 600. The shape, number, and/or arrangement of the solder portions S formed on the substrate 100 may be determined based on the type of the mask 600. The size and/or number of the LEDs 210 mounted on the substrate 100 may be determined based on the type of the mask 600. Hereinafter, a mask for implementing the first resolution (e.g., 8K) may be referred to/expressed as a first mask 600a. A mask for implementing the second resolution (e.g., 4K) that is relatively lower than the first resolution may be referred to/expressed as a second mask 600b or a third mask 600c.

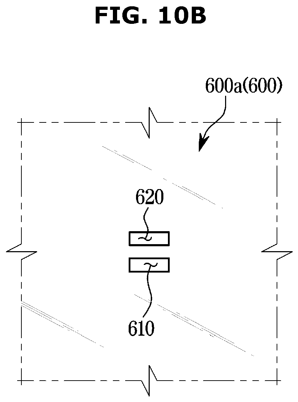

FIG. 10B illustrates the first mask 600a. The first mask 600a may include a first opening 610 and a second opening 620.

The first opening 610 may correspond to (e.g., overlap with) the first electrode pad 121, the third electrode pad 123, and a region between the first electrode pad 121 and the third electrode pad 123. The first opening 610 may be provided to form a first solder portion S1 to be described later. The first opening 610 may form the first solder portion S1 by allowing solder to pass through the first opening 610 and be disposed on the substrate 100.

The second opening 620 may correspond to (e.g., overlap with) the second electrode pad 122, the fourth electrode pad 124, and a region between the second electrode pad 122 and the fourth electrode pad 124. The second opening 620 may be provided to form a second solder portion S2 to be described later. The second opening 620 may form the second solder portion S2 by allowing solder to pass through the second opening 620 and be disposed on the substrate 100.

The first opening 610 and the second opening 620 may be spaced apart along the first direction D1. The first opening 610 and the second opening 620 may be arranged along the first direction D1.

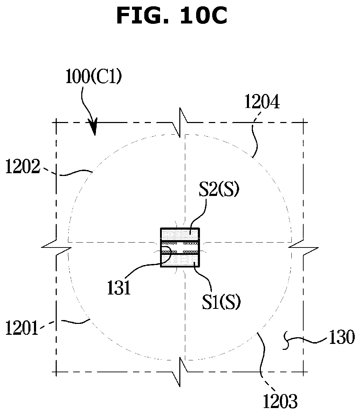

FIG. 10C illustrates a state in which the first mask 600a is disposed on the substrate 100, solder is applied to the first mask 600a, and then the first mask 600a is separated from the substrate 100.

The solder applied to the first mask 600a may be arranged to pass through the first opening 610 and the second opening 620 and be disposed on the substrate 100. As the first mask 600a is separated from the substrate 100, a solder portion S may be provided on the substrate 100.

The substrate 100 may be provided in a first state C1. The first solder portion S1 and the second solder portion S2 may be disposed on the substrate 100. The first solder portion S1 may be disposed to connect the first electrode pad 121 and the third electrode pad 123. As solder passes through the first opening 610 and is disposed on the substrate 100, the first solder portion S1 may be formed. The first solder portion S1 may be provided to cover the first electrode pad 121, the third electrode pad 123, and a region between the first electrode pad 121 and the third electrode pad 123. The second solder portion S2 may be disposed to connect the second electrode pad 122 and the fourth electrode pad 124. As the solder passes through the second opening 620 and is disposed on the substrate 100, the second solder portion S2 may be formed. The second solder portion S2 may be provided to cover the second electrode pad 122, the fourth electrode pad 124, and a region between the second electrode pad 122 and the fourth electrode pad 124. The first solder portion S1 and the second solder portion S2 may be disposed along the first direction D1.

FIG. 10D illustrates a state in which a single LED 210a is mounted on the substrate 100 provided with the first solder portion S1 and the second solder portion S2.

The LED 210a may be mounted on the substrate 100. The substrate 100 may be equipped with the LED 210a. The LED 210a may have a first size. For example, the LED 210a may have a size of approximately 500 µm x 500 µm.

Referring to FIG. 11, an anode 211a of the LED 210a may be disposed to be in contact with the first solder portion S1. The anode 211a of the LED 210a may be electrically connectable to the first electrode pad 121. The anode 211a of the LED 210a may be electrically connected to the first electrode pad 121 through the first solder portion S1. A cathode 212a of the LED 210a may be disposed to be in contact with the second solder portion S2. The cathode 212a of the LED 210a may be electrically connectable to the second electrode pad 122. The cathode 212a of the LED 210a may be electrically connected to the second electrode pad 122 through the second solder portion S2. The anode 211a of the LED 210a and the cathode 212a of the LED 210a may be arranged along the first direction D1.

In summary, the LED 210a may be mounted on the substrate 100 provided in the first state C1. While the substrate 100 is provided in the first state C1, the anode 211a of the LED 210a may be electrically connected to the first electrode pad 121, and the cathode 212a of the LED 210a may be electrically connected to the second electrode pad 122.

The light source apparatus 40 illustrated in FIGS. 8 to 11 may include the optical dome 220 and the LED 210a disposed within the optical dome 220. The size of the LED 210a may be relatively larger than the size of the LED 210b. The light source apparatus 40 illustrated in FIGS. 8 to 11 may implement a display apparatus having a relatively high resolution. For example, the light source apparatus 40 illustrated in FIGS. 8 to 11 may implement an 8K display apparatus. However, embodiments of the present disclosure are not limited to the above-described example, and the light source apparatus 40 may be provided as a component of a display apparatus having various resolutions.

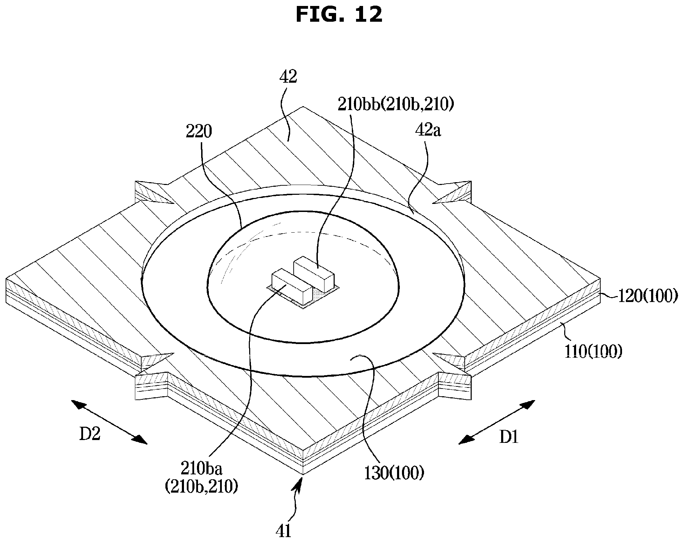

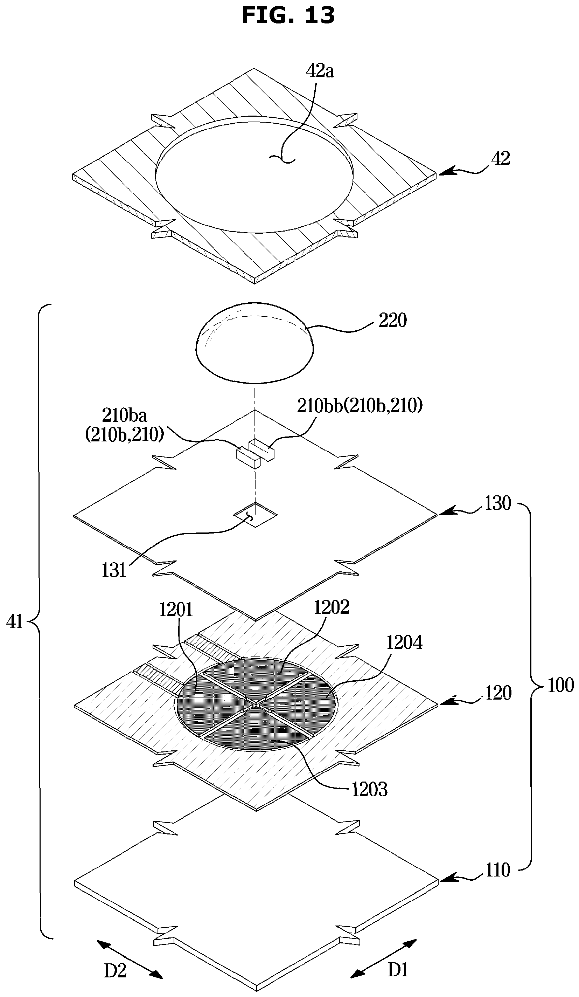

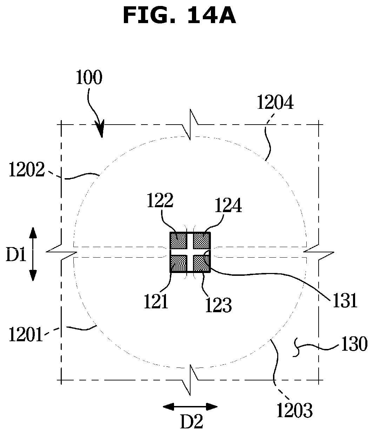

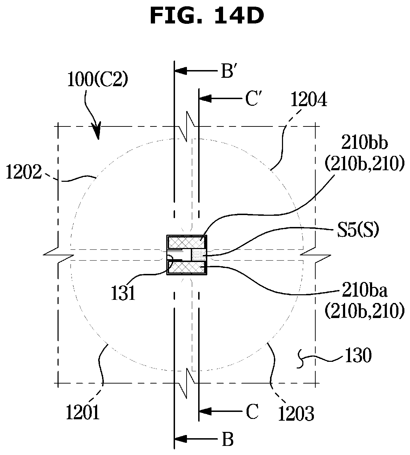

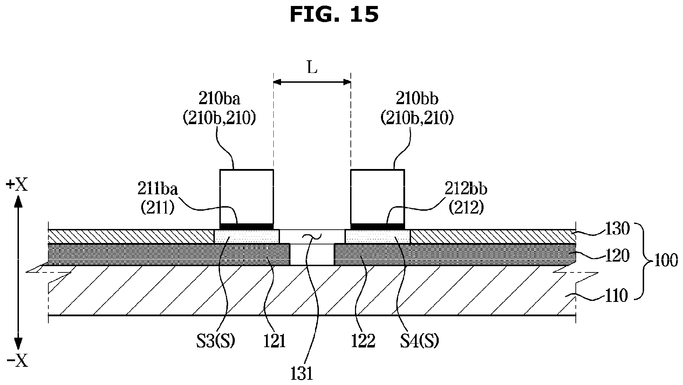

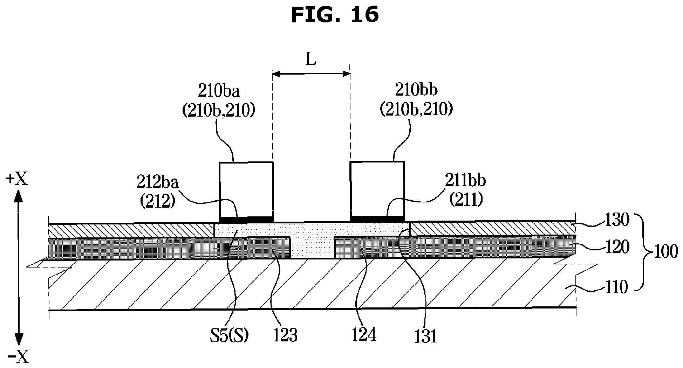

FIG. 12 is a perspective view of an example of a light source apparatus according to an embodiment. FIG. 13 is an exploded view of the light source apparatus shown in FIG. 12. FIGS. 14A-D schematically illustrates a manufacturing process of the light source apparatus of FIG. 12. FIG. 15 illustrates a cross-section taken along a line B-B' of FIG. 14D. FIG. 16 illustrates a cross-section taken along a line C-C' of FIG. 14D.

Descriptions that are the same as the above-described embodiment(s) may not be repeated. Components that are substantially the same as the previously described configuration are assigned the same reference numbers, and repeated detailed descriptions thereof may be omitted.

Referring to FIGS. 12 and 13, a light source apparatus 40 may include a light source module 41 and a reflective sheet 42. The light source module 41 may include a substrate 100 and a light source 200 disposed on the substrate 100.

The light source 200 may include a plurality of light emitting diodes (LEDs) 210b. The plurality of LEDs 210b may be electrically connected to each other. The plurality of LEDs 210b may be connected in series. Hereinafter for convenience of description, an example in which the light source 200 includes two LEDs 210b will be described, and one of the two LEDs 210b may be referred to/expressed as a first LED 210ba, and the other one of the two LEDs 210b may be referred to/expressed as a second LED 210bb. The second LED 210bb may be electrically connectable to the first LED 210ba. The second LED 210bb may be connected in series to the first LED 210ba.

An optical dome 220 may be provided to cover the plurality of LEDs 210b. The optical dome 220 may be provided to cover the first LED 210ba and the second LED 210bb. The first LED 210ba and the second LED 210bb may be disposed within the optical dome 220.

FIG. 14A illustrates the substrate 100. The substrate 100 illustrated in FIG. 14A is substantially the same as the substrate 100 illustrated in FIG. 10A. The substrate 100 may include a first electrode pad 121, a second electrode pad 122, a third electrode pad 123, and a fourth electrode pad 124. A positive voltage may be applied to the first electrode pad 121, and a negative voltage may be applied to the second electrode pad 122.

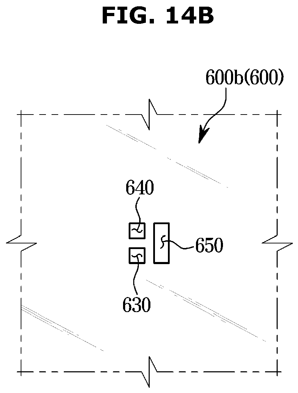

FIG. 14B illustrates a second mask 600b. The second mask 600b may include a third opening 630, a fourth opening 640, and a fifth opening 650.

The third opening 630 may correspond to (e.g., overlap with) the first electrode pad 121. The third opening 630 may be provided to form a third solder portion S3 to be described later. The third opening 630 may form the third solder portion S3 by allowing solder to pass through the third opening 630 and be disposed on the substrate 100.

The fourth opening 640 may correspond to (e.g., overlap with) the second electrode pad 122. The fourth opening 640 may be provided to form a fourth solder portion S4 to be described later. The fourth opening 640 may form the fourth solder portion S4 by allowing solder to pass through the fourth opening 640 and be disposed on the substrate 100.

The fifth opening 650 may correspond to (e.g., overlap with) the third electrode pad 123, the fourth electrode pad 124, and a region between the third electrode pad 123 and the fourth electrode pad 124. The fifth opening 650 may form a fifth solder portion S5 by allowing solder to pass through the fifth opening 650 and be disposed on the substrate 100.

The third opening 630 and the fourth opening 640 may be spaced apart along the first direction D1. The third opening 630 and the fourth opening 640 may be disposed along the first direction D1. The third opening 630 and the fifth opening 650 may be spaced apart along the second direction D2. The third opening 630 and the fifth opening 650 may be disposed along the second direction D2. The fourth opening 640 and the fifth opening 650 may be spaced apart along the second direction D2. The fourth opening 640 and the fifth opening 650 may be disposed along the second direction D2.

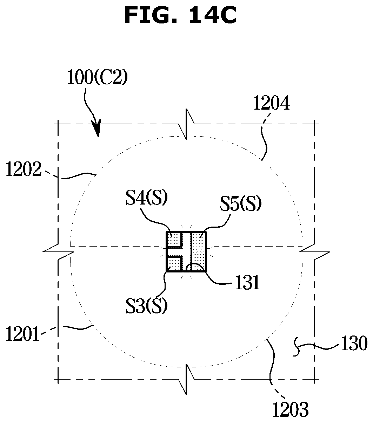

FIG. 14C illustrates a state in which a second mask 600b is disposed on the substrate 100, solder is applied to the second mask 600b, and then the second mask 600b is separated from the substrate 100.

Solder applied to the second mask 600b may be disposed to pass through the third opening 630, the fourth opening 640, and the fifth opening 650 and be disposed on the substrate 100. As the second mask 600b is separated from the substrate 100, a solder portion S may be provided on the substrate 100.

The substrate 100 may be provided in a second state C2. The third solder portion S3, the fourth solder portion S4, and the fifth solder portion S5 may be disposed on the substrate 100. The third solder portion S3 may be disposed on the first electrode pad 121. As the solder passes through the third opening 630 and is disposed on the substrate 100, the third solder portion S3 may be formed. The third solder portion S3 may be provided to cover the first electrode pad 121. The fourth solder portion S4 may be disposed on the second electrode pad 122. As the solder passes through the fourth opening 640 and is disposed on the substrate 100, the fourth solder portion S4 may be formed. The fourth solder portion S4 may be provided to cover the second electrode pad 122. The fifth solder portion S5 may be disposed to connect the third electrode pad 123 and the fourth electrode pad 124. As the solder passes through the fifth opening 650 and is disposed on the substrate 100, the fifth solder portion S5 may be formed. The fifth solder portion S5 may be provided to cover the third electrode pad 123, the fourth electrode pad 124, and a region between the third electrode pad 123 and the fourth electrode pad 124. The third solder portion S3 and the fourth solder portion S4 may be disposed along the first direction D1. The third solder portion S3 and the fifth solder portion S5 may be disposed along the second direction D2. The fourth solder portion S4 and the fifth solder portion S5 may be disposed along the second direction D2.

FIG. 14D illustrates a state in which the plurality of LEDs 210b is mounted on the substrate 100 provided with the third solder portion S3, the fourth solder portion S4, and the fifth solder portion S5.

The first LED 210ba and the second LED 210bb may be mounted on the substrate 100. The substrate 100 may be equipped with the first LED 210ba and the second LED 210bb. For example, each of the first LED 210ba and the second LED 210bb may have a size of approximately 400 µm x 220 µm.

Referring to FIG. 15, an anode 211ba of the first LED 210ba may be disposed to be in contact with the third solder portion S3. The anode 211ba of the first LED 210ba may be electrically connectable to the first electrode pad 121. The anode 211ba of the first LED 210ba may be electrically connected to the first electrode pad 121 through the third solder portion S3. A cathode 212bb of the second LED 210bb may be disposed to be in contact with the fourth solder portion S4. The cathode 212bb of the second LED 210bb may be electrically connectable to the second electrode pad 122. The cathode 212bb of the second LED 210bb may be electrically connected to the second electrode pad 122 through the fourth solder portion S4. The anode 211ba of the first LED 210ba and the cathode 212bb of the second LED 210bb may be arranged along the first direction D1.

Referring to FIG. 16, a cathode 212ba of the first LED 210ba may be disposed to be in contact with the fifth solder portion S5. An anode 211bb of the second LED 210bb may be disposed to be in contact with the fifth solder portion S5. The anode 211bb of the second LED 210bb may be electrically connectable to the cathode 212ba of the first LED 210ba. The cathode 212ba of the first LED 210ba and the anode 211bb of the second LED 210bb may be electrically connected through the fifth solder portion S5. The cathode 212ba of the first LED 210ba and the anode 211bb of the second LED 210bb may be arranged along the first direction D1.

In summary, the first LED 210ba and the second LED 210bb may be mounted on the substrate 100 provided in the second state C2. While the substrate 100 is provided in the second state C2, the anode 211ba of the first LED 210ba may be electrically connected to the first electrode pad 121, the cathode 212bb of the second LED 210bb may be electrically connected to the second electrode pad 122, and the cathode 212ba of the first LED 210ba and the anode 211bb of the second LED 210bb may be electrically connected through the fifth solder portion S5. As a result, the first LED 210ba and the second LED 210bb may be connected in series.

The light source apparatus 40 illustrated in FIGS. 12 to 15 may include the optical dome 220 and the plurality of LEDs 210b disposed within the optical dome 220. The size of each of the plurality of LEDs 210b may be relatively smaller than the size of the LED 210a. The light source apparatus 40 illustrated in FIGS. 12 to 15 may implement a display apparatus having a relatively lower resolution than the light source apparatus 40 illustrated in FIGS. 8 to 11. For example, the light source apparatus 40 illustrated in FIGS. 12 to 15 may implement a 4K display apparatus. However, embodiments of the present disclosure are not limited to the above-described example, and the light source apparatus 40 may be provided as a component of a display apparatus having various resolutions.

Meanwhile, the plurality of LEDs may be disposed to be spaced apart from each other on the substrate 100. The first LED 210ba and the second LED 210bb may be disposed to be spaced apart from each other on the substrate 100. The second LED 210bb may be spaced apart from the first LED 210ba. The second LED 210bb may be spaced apart from the first LED 210ba along the first direction D1. The first LED 210ba and the second LED 210bb may be arranged along the first direction D1.

As a distance L between the first LED 210ba and the second LED 210bb becomes smaller, a luminance of the light source 200 may be improved. In addition, as the distance L between the first LED 210ba and the second LED 210bb is reduced, the optical defect (e.g., mura) of the light source 200 may be prevented or reduced. However, it is practically impossible to indefinitely minimize the distance L between the first LED 210ba and the second LED 210bb.

In consideration of the luminance performance and manufacturing efficiency of the light source 200, it is appropriate that the distance L between the first LED 210ba and the second LED 210bb be in a range of approximately 100 µm to 300 µm.

When the distance L is designed to be less than 100 µm, it may be very difficult to mount the first LED 210ba and the second LED 210bb on the substrate 100. For example, in a light emitting diode mounting process, there may be limitations on movement of a mounting device. In order to stably mount the first LED 210ba and the second LED 210bb on the substrate 100, the distance L may be approximately 100 µm or more.

When the distance L is designed to be greater than 300 µm, the luminance of the light source 200 may be reduced as described above. In addition, it may be required that the optical dome 220 cover both the first LED 210ba and the second LED 210bb, and when the distance L is large, a lot of raw materials (e.g., silicon, epoxy resin, etc.) may be used to form the optical dome 220. In addition, it may be required that the raw materials forming the optical dome 220 be injected to the LEDs 210b multiple times, which may increase the process time. In order to secure the luminance of the light source 200 while increasing the manufacturing efficiency, the distance L may be approximately 300 µm or less.

In general, a substrate manufactured for each resolution may be required to implement a display apparatus. For example, a first substrate of the light source apparatus used to implement an 8K display apparatus and a second substrate of the light source apparatus used to implement a 4K display apparatus may be different. The first substrate and the second substrate may have different arrangements of wiring and/or components. Accordingly, in order to manufacture a plurality of display apparatuses with different resolutions, substrates suitable for each of the plurality of display apparatuses may be required. Accordingly, many production lines may be required to manufacture each substrate. In addition, it is not easy to manage various types of substrates.

In contrast, according to embodiments of the present disclosure, display apparatuses having various resolutions may be implemented using a single substrate 100. For example, in order to implement an 8K display apparatus and a 4K display apparatus, one type of substrate 100 may be required. As described above, various combinations of solder portions S may be formed on one substrate 100 using various types of masks 600. Depending on the shape and/or arrangement of the solder portions S provided on the substrate 100, the size, number, etc., of the LEDs 210 mounted on the substrate 100 may vary. As a result, both a high-resolution display apparatus and a low-resolution display apparatus may be manufactured using only one substrate 100. Accordingly, the number of production lines for producing the substrate may be reduced, and the management of the substrate may be facilitated. As a result, the manufacturing efficiency of the substrate 100 and the manufacturing efficiency of the light source apparatus 40 including the substrate 100 may be increased.

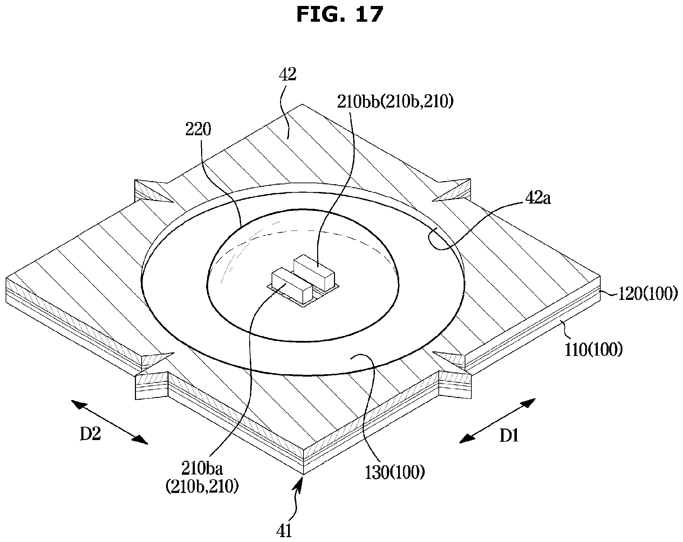

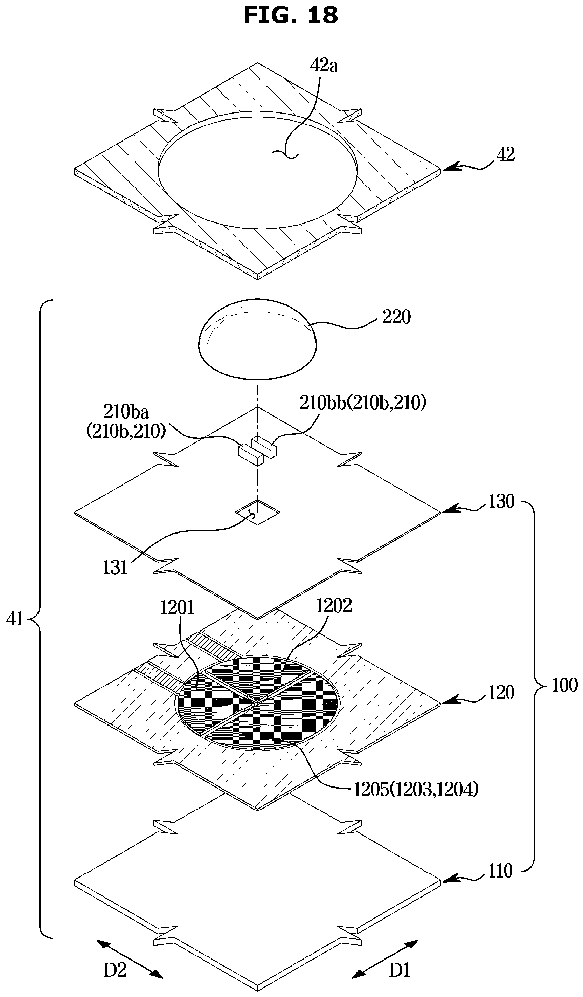

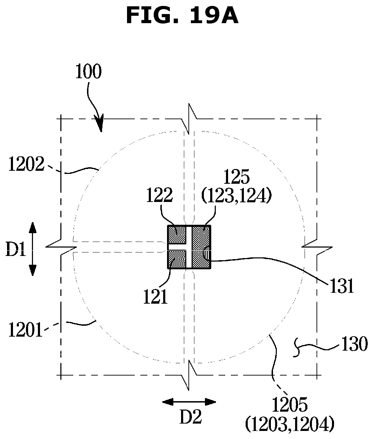

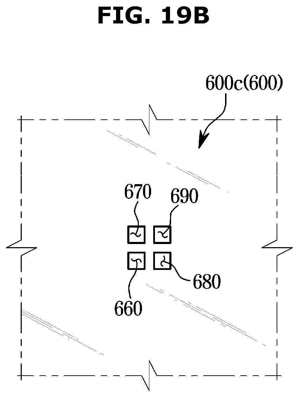

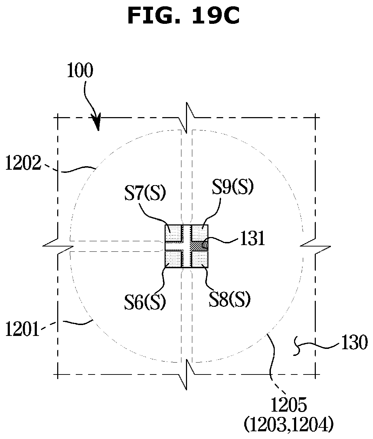

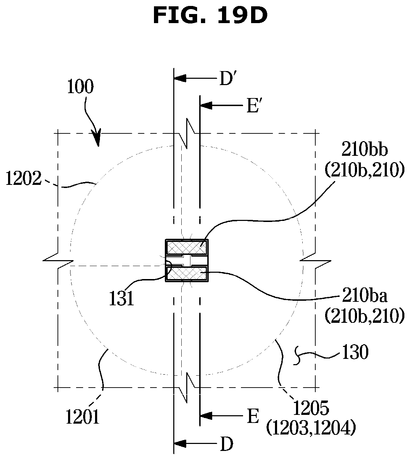

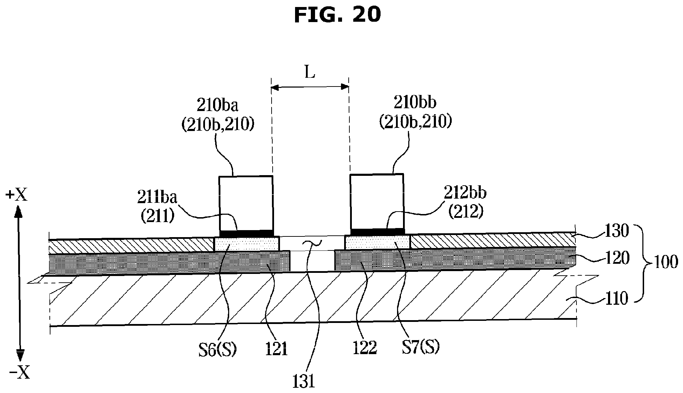

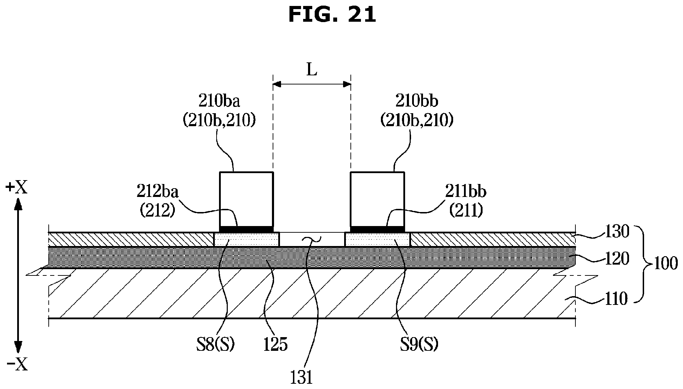

FIG. 17 is a perspective view of an example of a light source apparatus according to an embodiment. FIG. 18 is an exploded view of the light source apparatus shown in FIG. 17. FIGS. 19A-D schematically illustrates a manufacturing process of the light source apparatus shown in FIG. 17. FIG. 20 illustrates a cross-section taken along a line D-D' shown in FIG. 19D. FIG. 21 illustrates a cross-section taken along a line E-E' shown in FIG. 19.

Descriptions that are the same as the above-described embodiment(s) may not be repeated. Components that are substantially the same as the previously described configuration are assigned the same reference numbers, and repeated detailed descriptions thereof may be omitted.

Referring to FIGS. 17 and 18, a light source apparatus 40 may include a light source module 41 and a reflective sheet 42. The light source module 41 may include a substrate 100 and a light source 200 disposed on the substrate 100.

The light source 200 may include a plurality of light emitting diode (LED) s 210b. The light source 200 may include a first LED 210ba and a second LED 210bb. The light source 200 may include an optical dome 220. The optical dome 220 may be provided to cover the first LED 210ba and the second LED 210bb.

FIG. 19A illustrates the substrate 100. The substrate 100 illustrated in FIG. 19A may be partially different from the substrate 100 illustrated in FIG. 10A in that the substrate 100 illustrated in FIG. 19A may include a fifth electrode pad 125. The substrate 100 illustrated in FIG. 19A may be substantially the same as the substrate 100 illustrated in FIG. 10A except for the fifth electrode pad 125.

The substrate 100 may include a first electrode pad 121, a second electrode pad 122, and the fifth electrode pad 125. A third electrode pad 123 and a fourth electrode pad 124 may be formed integrally, and the third electrode pad 123 and the fourth electrode pad 124 formed integrally may be referred to as the fifth electrode pad 125. For example, a fifth electrode pattern 1205 may be formed as a third electrode pattern 1203 and a fourth electrode pattern 1204 are provided integrally. The fifth electrode pad 125 may be formed as the fifth electrode pattern 1205 is exposed to the outside of the substrate through an exposed portion 131 of a protection layer 130. The fifth electrode pad 125 may be spaced apart from the first electrode pad 121 with respect to the second direction D2. The first electrode pad 121 and the fifth electrode pad 125 may be arranged along the second direction D2. The fifth electrode pad 125 may be spaced apart from the second electrode pad 122 with respect to the second direction D2. The second electrode pad 122 and the fifth electrode pad 125 may be disposed along the second direction D2.

FIG. 19B illustrates a third mask 600c. The third mask 600c may include a sixth opening 660, a seventh opening 670, an eighth opening 680, and a ninth opening 690.

The sixth opening 660 may correspond to (e.g., overlap with) the first electrode pad 121. The sixth opening 660 may be provided to form a sixth solder portion S6 to be described later. The sixth opening 660 may form the sixth solder portion S6 by allowing solder to pass through the sixth opening 660 and be disposed on the substrate 100.

The seventh opening 670 may correspond to (e.g., overlap with) the second electrode pad 122. The seventh opening 670 may be provided to form a seventh solder portion S7 to be described later. The seventh opening 670 may form the seventh solder portion S7 by allowing solder to pass through the seventh opening 670 and be disposed on the substrate 100.

The eighth opening 680 may correspond to (e.g., overlap with) a portion of the fifth electrode pad 125. The eighth opening 680 may correspond to a portion of the third electrode pad 123 and the fourth electrode pad 124 that are formed integrally. The eighth opening 680 may be provided to form an eighth solder portion S8 to be described later. The eighth opening 680 may form the eighth solder portion S8 by allowing solder to pass through the eighth opening 680 and be disposed on the substrate 100.

The ninth opening 690 may correspond to a remaining portion of the fifth electrode pad 125. The ninth opening 690 may correspond to a remaining portion of the third electrode pad 123 and the fourth electrode pad 124 that are formed integrally. The ninth opening 690 may be provided to form a ninth solder portion S9 to be described later. The ninth opening 690 may form the ninth solder portion S9 by allowing solder to pass through the ninth opening 690 and be disposed on the substrate 100.

The sixth opening 660 and the seventh opening 670 may be spaced apart along the first direction D1. The sixth opening 660 and the seventh opening 670 may be arranged along the first direction D1. The eighth opening 680 and the ninth opening 690 may be spaced apart along the first direction D1. The eighth opening 680 and the ninth opening 690 may be arranged along the first direction D1. The sixth opening 660 and the eighth opening 680 may be spaced apart along the second direction D2. The sixth opening 660 and the eighth opening 680 may be arranged along the second direction D2. The seventh opening 670 and the ninth opening 690 may be spaced apart along the second direction D2. The seventh opening 670 and the ninth opening 690 may be arranged along the second direction D2.

FIG. 19C illustrates a state in which a third mask 600c is disposed on the substrate 100, solder is applied to the third mask 600c, and then the third mask 600c is separated from the substrate 100.

Solder applied to the third mask 600c may be disposed to pass through the sixth opening 660, the seventh opening 670, the eighth opening 680, and the ninth opening 690 and be disposed on the substrate 100. As the third mask 600c is separated from the substrate 100, a solder portion S may be provided on the substrate 100.

The sixth solder portion S6, the seventh solder portion S7, the eighth solder portion S8, and the ninth solder portion S9 may be disposed on the substrate 100. The sixth solder portion S6 may be disposed on the first electrode pad 121. As solder passes through the sixth opening 660 and is disposed on the substrate 100, the sixth solder portion S6 may be formed. The sixth solder portion S6 may be provided to cover the first electrode pad 121. The seventh solder portion S6 may be disposed on the second electrode pad 122. As solder passes through the seventh opening 670 and is disposed on the substrate 100, the seventh solder portion S7 may be formed. The seventh solder portion S7 may be provided to cover the second electrode pad 122. The eighth solder portion S8 may be disposed on a portion of the fifth electrode pad 125. As the solder passes through the eighth opening 680 and is disposed on the substrate 100, the eighth solder portion S8 may be formed. The eighth solder portion S8 may be provided to cover a portion of the fifth electrode pad 125. The eighth solder portion S8 may cover a portion of the third electrode pad 123 and the fourth electrode pad 124 that are formed integrally. The ninth solder portion S9 may be disposed on a remaining portion of the fifth electrode pad 125. As the solder passes through the ninth opening 690 and is disposed on the substrate 100, the ninth solder portion S9 may be formed. The ninth solder portion S9 may be provided to cover the remaining portion of the fifth electrode pad 125. The ninth solder portion S9 may cover a remaining portion of the third electrode pad 123 and the fourth electrode pad 124 that are formed integrally. The sixth solder portion S6 and the seventh solder portion S7 may be arranged along the first direction D1. The eighth solder portion S8 and the ninth solder portion S9 may be arranged along the first direction D1. The sixth solder portion S6 and the eighth solder portion S8 may be arranged along the second direction D2. The seventh solder portion S7 and the ninth solder portion S9 may be arranged along the second direction D2.

FIG. 19D illustrates a state in which the plurality of LEDs 210b is mounted on the substrate 100 provided with the sixth solder portion S6, the seventh solder portion S7, the eighth solder portion S8, and the ninth solder portion S9.

The first LED 210ba and the second LED 210bb may be mounted on the substrate 100. The substrate 100 may be equipped with the first LED 210ba and the second LED 210bb. For example, each of the first LED 210ba and the second LED 210bb may have a size of approximately 400 µm x 220 µm.

The first LED 210ba and the second LED 210bb may be spaced apart. For example, a distance L between the first LED 210ba and the second LED 210bb may be approximately 100 µm to 300 µm.

Referring to FIG. 20, the anode 211ba of the first LED 210ba may be disposed to be in contact with the sixth solder portion S6. The anode 211ba of the first LED 210ba may be electrically connectable to the first electrode pad 121. The anode 211ba of the first LED 210ba may be electrically connected to the first electrode pad 121 through the sixth solder portion S6. The cathode 212bb of the second LED 210bb may be disposed to be in contact with the seventh solder portion S7. The cathode 212bb of the second LED 210bb may be electrically connectable to the second electrode pad 122. The cathode 212bb of the second LED 210bb may be electrically connected to the second electrode pad 122 through the seventh solder portion S7. The anode 211ba of the first LED 210ba and the cathode 212bb of the second LED 210bb may be arranged along the first direction D1.

Referring to FIG. 21, the cathode 212ba of the first LED 210ba may be disposed to be in contact with the eighth solder portion S8. The cathode 212ba of the first LED 210ba may be electrically connectable to the fifth electrode pad 125. The cathode 212ba of the first LED 210ba may be electrically connected to the fifth electrode pad 125 through the eighth solder portion S8. For example, the third electrode pad 123 and the fourth electrode pad 124 may be formed integrally to form the fifth electrode pad 125. At this time, the cathode 212ba of the first LED 210ba may be disposed on a portion of the third electrode pad 123 and the fourth electrode pad 124 that are formed integrally. The anode 211bb of the second LED 210bb may be disposed to be in contact with the ninth solder portion S9. The anode 211bb of the second LED 210bb may be electrically connectable to the fifth electrode pad 125. The anode 211bb of the second LED 210bb may be electrically connected to the fifth electrode pad 125 through the ninth solder portion S9. For example, the third electrode pad 123 and the fourth electrode pad 124 may be formed integrally so as to form the fifth electrode pad 125. At this time, the anode 211bb of the second LED 210bb may be disposed on a remaining portion of the third electrode pad 123 and the fourth electrode pad 124 that are formed integrally. The cathode 212ba of the first LED 210ba and the anode 211bb of the second LED 210bb are electrically connectable. The cathode 212ba of the first LED 210ba and the anode 211bb of the second LED 210bb may be electrically connected through the fifth electrode pad 125. The cathode 212ba of the first LED 210ba and the anode 211bb of the second LED 210bb may be disposed along the first direction D1.

The anode 211ba of the first LED 210ba may be electrically connected to the first electrode pad 121, the cathode 212bb of the second LED 210bb may be electrically connected to the second electrode pad 122, and the cathode 212ba of the first LED 210ba and the anode 211bb of the second LED 210bb may be electrically connected through the fifth electrode pad 125. As a result, the first LED 210ba and the second LED 210bb may be connected in series.

Meanwhile, the third mask 600c illustrated in FIG. 19B may be replaced with the second mask 600b illustrated in FIG. 14B. Accordingly, the shape of the solder portion S illustrated in FIG. 19C may be replaced with the shape of the solder portion S illustrated in FIG. 14C. At this time, the eighth solder portion S8 and the ninth solder portion S9 illustrated in FIG. 19C may be provided integrally. In addition, in FIG. 21, a space between the eighth solder portion S8 and the ninth solder portion S9 may be filled with solder.

According to various embodiments, each of the plurality of light sources 200 may include the plurality of LEDs 210b and the optical dome 220 for covering the plurality of LEDs 210b. When the plurality of LEDs 210b is disposed within the optical dome 220, the image quality may be improved compared to the same driving voltage. For example, when the plurality of LEDs 210b is disposed within the optical dome 220 wherein the number of LEDs is the same, an area of the dimming block 300 itself may be reduced compared to other cases. Further, when the plurality of LEDs 210b is disposed within the optical dome 220 where the number of LEDs is the same, the number of through-holes 42a of the reflective sheet 42 may be reduced compared to other cases. As a result, the reflection efficiency of the reflective sheet 42 may be improved.

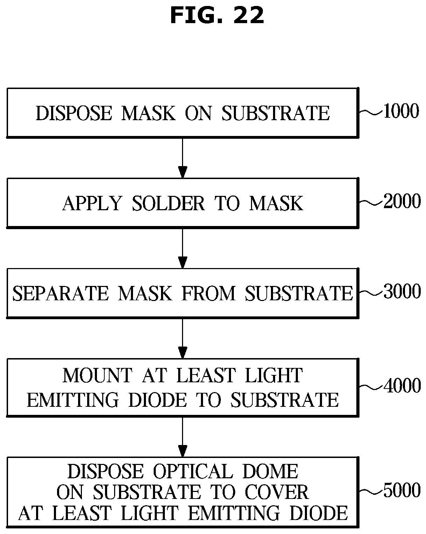

FIG. 22 illustrates an example of a manufacturing method of the light source apparatus according to an embodiment.

A manufacturing method of the light source apparatus 40 according to an embodiment may include disposing the mask 600 on the substrate 100 (operation 1000). The substrate 100 may include the first electrode pad 121, the second electrode pad 122, the third electrode pad 123, and the fourth electrode pad 124. For example, the third electrode pad 123 and the fourth electrode pad 124 may be formed integrally. The mask 600 may be provided in various types. After selecting a type of mask 600 based on a resolution to be implemented, the selected mask 600 may be disposed on the substrate 100. For example, the first mask 600a may include the first opening 610 and the second opening 620 (refer to FIG. 10B). For example, the second mask 600b may include the third opening 630, the fourth opening 640, and the fifth opening 650 (refer to FIG. 14B). For example, the third mask 600c may include the sixth opening 660, the seventh opening 670, the eighth opening 680, and the ninth opening 690.

The manufacturing method of the light source apparatus 40 according to an embodiment may include applying solder to the mask 600 (operation 2000). The solder may be applied while the mask 600 is disposed on the substrate 100. The solder applied to the mask 600 may be pressed to be inserted into the opening of the mask 600. For example, based on the first mask 600a being selected, the solder applied to the first mask 600a may pass through the first opening 610 and the second opening 620 and be disposed on the substrate 100. For example, based on the second mask 600b being selected, the solder applied to the second mask 600b may pass through the third opening 630, the fourth opening 640, and the fifth opening 650 and be disposed on the substrate 100. For example, based on the third mask 600c being selected, the solder applied to the third mask 600c may pass through the sixth opening 660, the seventh opening 670, the eighth opening 680, and the ninth opening 690 and be disposed on the substrate 100.

The manufacturing method of the light source apparatus 40 according to an embodiment may include separating the mask 600 from the substrate 100 (operation 3000). As the mask 600 is separated from the substrate 100, solder may remain in a region corresponding to the opening of the mask 600. That is, the solder portion S may be formed on the substrate 100. For example, based on the first mask 600a being selected, the first solder portion S1 and the second solder portion S2 may be formed on the substrate 100 as the first mask 600a may be separated from the substrate 100 (refer to FIG. 10C). For example, based on the second mask 600b being selected, the third solder portion S3, the fourth solder portion S4, and the fifth solder portion S5 may be formed on the substrate 100 by separating the second mask 600b from the substrate 100 (refer to FIG. 14C). For example, based on the third mask 600c being selected, the sixth solder portion S6, the seventh solder portion S7, the eighth solder portion S8, and the ninth solder portion S9 may be formed on the substrate 100 by separating the third mask 600c from the substrate 100 (refer to FIG. 19C).

The manufacturing method of the light source apparatus 40 according to an embodiment may include mounting at least one LED 210 on the substrate 100 (operation 4000). The LED 210 may be electrically connected to the electrode pads (e.g., the first electrode pad 121, the second electrode pad 122, the third electrode pad 123 and/or the fourth electrode pad 124) as the LED 210 is mounted on the substrate 100. At least one electrode 211 and/or 212 of the LED 210 may be in electrical contact with the solder portion S. For example, based on the first mask 600a being selected, one LED 210a may be mounted on the substrate 100 (refer to FIG. 10D). For example, based on the second mask 600b or the third mask 600c being selected, the plurality of LEDs 210b may be mounted on the substrate 100, and the plurality of LEDs 210b may be connected in series with each other (refer to FIG. 14D and FIG. 19D).

The manufacturing method of the light source apparatus 40 according to an embodiment may include disposing the optical dome 220 on the substrate 100 to cover at least one diode (e.g., LED 210) (operation 5000). The at least one diode (e.g., the LED 210) may be disposed within the optical dome 220. For example, based on the first mask 600a being selected, the optical dome 220 may be provided to cover one LED 210a. For example, based on the second mask 600b or the third mask 600c being selected, the optical dome 220 may be provided to cover the plurality of LEDs 210b. For example, the optical dome 220 may be provided to cover both the first LED 210ba and the second LED 210bb.

According to an embodiment of the present disclosure, the light source apparatus 40 may include the substrate 100; the light emitting diode (LED) 210 mountable on the substrate 100; and the optical dome 220 disposed on the substrate 100 to cover the LED 210. The substrate 100 may include the first electrode pad 121 to which a positive voltage is applied; the second electrode pad 122 to which a negative voltage is applied, the second electrode pad spaced apart from the first electrode pad 121 in the first direction D1; the third electrode pad 123 spaced apart from the first electrode pad 121 in the second direction D2 intersecting the first direction D1; and the fourth electrode pad 124 spaced apart from the second electrode pad 122 in the second direction D2.

The substrate 100 may be provided in the first state C1 or the second state C2. The substrate 100 may be provided in the first state C1 in which the first solder portion S1 is disposed to connect the first electrode pad 121 and the third electrode pad 123, and the second solder portion S2 is disposed to connect the second electrode pad 122 and the fourth electrode pad 124. The substrate 100 may be provided in the second state S2 in which the third solder portion S3 is disposed on the first electrode pad 121, the fourth solder portion S4 is disposed on the second electrode pad 122, and the fifth solder portion S5 is disposed to connect the third electrode pad 123 and the fourth electrode pad 124.

Based on the substrate 100 being in the first state C1, the LED 210 may be a single first light emitting diode 210a having the first size. Based on the substrate 100 being in the second state C2, the LED 210 may be a plurality of second LEDs 210b having the second size smaller than the first size.

While the substrate 100 is provided in the first state, the anode 211a of the LED 210a may be provided to be in contact with the first solder portion S1 and electrically connectable to the first electrode pad 121. While the substrate 100 is provided in the first state, the cathode 212a of the LED 210a may be provided to be in contact with the second solder portion S2 and electrically connectable to the second electrode pad 122.

The LED may be the first LED 210ba. The light source apparatus 40 may further include the second LED 210bb electrically connectable to the first LED and provided to be covered by the optical dome 220. While the substrate 100 is provided in the second state C2, the anode 211ba of the first LED 210ba may be provided to be in contact with the third solder portion S3 and electrically connectable to the first electrode pad 121. While the substrate 100 is provided in the second state C2, the cathode 212ba of the first LED 210ba may be provided to be in contact with the fifth solder portion S5. While the substrate 100 is provided in the second state C2, the anode 211bb of the second LED 210bb may be provided to be in contact with the fifth solder portion S5 and electrically connectable to the cathode 212ba of the first LED 210ba. While the substrate 100 is provided in the second state C2, the cathode 212bb of the second LED 210bb may be provided to be in contact with the fourth solder portion S4 and electrically connectable to the second electrode pad 122.

Based on the first mask 600a being disposed on the substrate 100 and solder being applied, and then the first mask 600a being separated from the substrate 100, the first solder portion S1 may be disposed to connect the first electrode pad 121 and the third electrode pad 123, and the second solder portion S2 may be disposed to connect the second electrode pad 122 and the fourth electrode pad 124. Based on the second mask 600b being disposed on the substrate 100 and solder being applied, and then the second mask 600b being separated from the substrate 100, the third solder portion S3 may be disposed on the first electrode pad 121, the fourth solder portion S4 may be disposed on the second electrode pad 122, and the fifth solder portion S5 may be disposed to connect the third electrode pad 123 and the fourth electrode pad 124.

The first mask 600a may include the first opening 610 corresponding to (e.g., overlapping with) the first electrode pad 121, the third electrode pad 123, and the region between the first electrode pad and the third electrode pad, the first opening for forming the first solder portion by allowing the solder to pass through the first opening and be disposed on the substrate. The first mask 600a may include the second opening 620 corresponding to (e.g., overlapping with) the second electrode pad 122, the fourth electrode pad 124, and the region between the second electrode pad and the fourth electrode pad, the second opening for forming the second solder portion by allowing the solder to pass through the second opening and be disposed on the substrate.

The second mask 600b may include the first opening 630 corresponding to (e.g., overlapping with) the first electrode pad 121, and for forming the third solder portion S3 by allowing the solder to pass through the first opening and be disposed on the substrate. The second mask 600b may include the second opening 640 corresponding to (e.g., overlapping with) the second electrode pad 122, and for forming the fourth solder portion S4 by allowing the solder to pass through the second opening and be disposed on the substrate. The second mask 600b may include the third opening 650 corresponding to (e.g., overlapping with) the third electrode pad 123, the fourth electrode pad 124, and the region between the third electrode pad and the fourth electrode pad, the third opening for forming the fifth solder portion S5 by allowing the solder to pass through the third opening and be disposed on the substrate.

The LED may be the first LED 210ba. The light source apparatus 40 may further include the second LED 210bb spaced apart from the first LED 210ba and provided to be covered by the optical dome 220.

The first LED 210ba and the second LED 210bb may be arranged along the first direction.

The distance L between the first LED 210ba and the second LED 210bb may be 100 µm to 300 µm.

The third electrode pad 123 and the fourth electrode pad 124 may be formed integrally.

The cathode 212ba of the first LED 210ba may be disposed on a portion of the third electrode pad 123 and the fourth electrode pad 124. The anode 211bb of the second LED 210bb may be disposed on a remaining portion of the third electrode pad 123 and the fourth electrode pad 124.

The first electrode pad 121 and the fourth electrode pad 124 may be arranged diagonally with respect to the first direction D1 and the second direction D2. The second electrode pad 122 and the third electrode pad 123 may be arranged in the diagonal direction.

The substrate 100 may include the base 110 having insulating properties, the conduction layer 120 disposed on the base, and the protection layer 130 disposed on the conduction layer and including the exposed portion 131 provided to expose a portion of the conduction layer. The first electrode pad 121, the second electrode pad 122, the third electrode pad 123, and the fourth electrode pad 124 may be formed as the conduction layer 120 is exposed through the exposed portion 131.

According to an embodiment of the present disclosure, the manufacturing method of the light source apparatus 40 including the substrate 100, the at least one light emitting diode (LED) 210, and the optical dome 220, may include disposing the mask 600 on the substrate 100 (1000); applying solder on the mask 600 (2000); separating the mask 600 from the substrate 100 (3000); mounting the at least one LED 210 to the substrate 100 (4000); and disposing the optical dome 220 on the substrate 100 to cover the at least one LED 210 (5000). The substrate 100 may include the first electrode pad 121 to which a positive voltage is applied; the second electrode pad 122 to which a negative voltage is applied, the second electrode pad spaced apart from the first electrode pad 121 in the first direction D1; the third electrode pad 123 spaced apart from the first electrode pad 121 in the second direction D2 intersecting the first direction D1; and the fourth electrode pad 124 spaced apart from the second electrode pad 122 in the second direction D2.

The mask 600a may include the first opening 610 corresponding to (e.g., overlapping with) the first electrode pad 121, the third electrode pad 123, and the region between the first electrode pad and the third electrode pad, and the second opening 620 corresponding to (e.g., overlapping with) the second electrode pad 122, the fourth electrode pad 124, and the region between the second electrode pad and the fourth electrode pad. Solder applied to the mask 600a may pass through the first opening 610 and the second opening 620 and be disposed on the substrate 100.

The mask 600b may include the third opening 630 corresponding to (e.g., overlapping with) the first electrode pad 121, the fourth opening 640 corresponding to (e.g., overlapping with) the second electrode pad 122, and the fifth opening 650 corresponding to (e.g., overlapping with) the third electrode pad 123, the fourth electrode pad 124, and the region between the third electrode pad and the fourth electrode pad. Solder applied to the mask 600b may pass through the third opening 630, the fourth opening 640, and the fifth opening 650 and be disposed on the substrate 100.

The third electrode pad 123 and the fourth electrode pad 124 may be formed integrally. The mask 600c may include the sixth opening 660 corresponding to (e.g., overlapping with) the first electrode pad 121, the seventh opening 670 corresponding to (e.g., overlapping with) the second electrode pad 122, the eighth opening 680 corresponding to (e.g., overlapping with) a portion of the third electrode pad 123 and the fourth electrode pad 124, and the ninth opening 690 corresponding to (e.g., overlapping with) a remaining portion of the third electrode pad 123 and the fourth electrode pad 124. Solder applied to the mask may pass through the sixth opening 660, the seventh opening 670, the eighth opening 680, and the ninth opening 690 and be disposed on the substrate 100.

The at least one LED 210 may include the first LED 210ba covered by the optical dome 220, and the second LED 210bb spaced apart from the first LED 210ba in the first direction D1 and covered by the optical dome 220.

According to various embodiments of the present disclosure, it is possible to implement a light source apparatus having various resolutions using a single substrate. For example, a substrate for a 4K display apparatus and a substrate for an 8K display apparatus may not be required. The 4K display apparatus and the 8K display apparatus may be manufactured using only one type of substrate. As a result, the number of production lines may be reduced, and substrate management may be facilitated. The manufacturing efficiency of the light source apparatus may be increased.

According to various embodiments of the present disclosure, a plurality of light emitting diodes may be arranged within one optical dome. It is possible to provide a light source apparatus having improved luminance and image quality compared to the same driving voltage.

Additional aspects of the present disclosure will be understood from the description, or may be learned by practice of the present disclosure.

While non-limiting example embodiments of the present disclosure have been particularly described with reference to the accompanying drawings, it should be understood by those of skilled in the art that various changes in form and details may be made without departing from the spirit and scope of the present disclosure.

## Claims

1. A light source apparatus comprising:
a substrate;
at least one light emitting diode on the substrate; and
an optical dome on the substrate and covering the at least one light emitting diode;
wherein the substrate comprises:
a first electrode pad configured to receive a positive voltage;
a second electrode pad configured to receive a negative voltage, the second electrode pad spaced apart from the first electrode pad in a first direction;
a third electrode pad spaced apart from the first electrode pad in a second direction intersecting the first direction; and
a fourth electrode pad spaced apart from the second electrode pad in the second direction.

2. The light source apparatus of claim 1, further comprising:
a first solder portion connecting the first electrode pad and the third electrode pad; and
a second solder portion connecting the second electrode pad and the fourth electrode pad.

3. The light source apparatus of claim 1, further comprising:
a first solder portion on the first electrode pad;
a second solder portion on the second electrode pad; and
a third solder portion connecting the third electrode pad and the fourth electrode pad.

4. The light source apparatus of claim 2, wherein the at least one light emitting diode is a single light emitting diode.

5. The light source apparatus of claim 3, wherein the at least one light emitting diode is a plurality of light emitting diodes.

6. The light source apparatus of claim 2, wherein
an anode of the at least one light emitting diode is in contact with the first solder portion and is electrically connected to the first electrode pad; and
a cathode of the at least one light emitting diode is in contact with the second solder portion and is electrically connected to the second electrode pad.

7. The light source apparatus of claim 3, wherein
the at least one light emitting diode comprises a first light emitting diode and a second light emitting diode that are electrically connected to each other and covered by the optical dome,
an anode of the first light emitting diode is in contact with the first solder portion and is electrically connected to the first electrode pad,
a cathode of the first light emitting diode is in contact with the third solder portion,
an anode of the second light emitting diode is in contact with the third solder portion and is electrically connected to the cathode of the first light emitting diode; and
a cathode of the second light emitting diode is in contact with the second solder portion and is electrically connected to the second electrode pad.

8. The light source apparatus of claim 1, wherein
the at least one light emitting diode comprises a first light emitting diode and a second light emitting diode that are spaced apart from each other and are covered by the optical dome.

9. The light source apparatus of claim 8, wherein
the first light emitting diode and the second light emitting diode are arranged along the first direction.

10. The light source apparatus of claim 8, wherein
a distance between the first light emitting diode and the second light emitting diode is 100 µm to 300 µm.

11. The light source apparatus of claim 8, wherein
the third electrode pad and the fourth electrode pad are formed integrally with respect to each other.

12. The light source apparatus of claim 11, wherein
a cathode of the first light emitting diode is on a portion of the third electrode pad and a portion of the fourth electrode pad; and
an anode of the second light emitting diode is on another portion of the third electrode pad and another portion of the fourth electrode pad.

13. The light source apparatus of claim 1, wherein
the first electrode pad and the fourth electrode pad are arranged diagonally with respect to the first direction and the second direction; and
the second electrode pad and the third electrode pad are arranged in the diagonal direction.

14. The light source apparatus of claim 1, wherein the substrate comprises:
a base having insulating properties;
a conduction layer on the base; and
a protection layer on the conduction layer and comprising a window that exposes a portion of the conduction layer, and
wherein the first electrode pad, the second electrode pad, the third electrode pad, and the fourth electrode pad are formed as the conduction layer is exposed through the window.

15. A method of manufacturing a light source apparatus, the method comprising:
disposing a mask on a substrate;
applying solder to the mask;
separating the mask from the substrate;
mounting at least one light emitting diode on the substrate; and
covering the at least one light emitting diode with at least one optical dome,
wherein the substrate includes:
a first electrode pad configured to receive a positive voltage;
a second electrode pad configured to receive a negative voltage, the second electrode pad spaced apart from the first electrode pad in a first direction;
a third electrode pad spaced apart from the first electrode pad in a second direction intersecting the first direction; and
a fourth electrode pad spaced apart from the second electrode pad in the second direction.
